**Europäisches Patentamt**

**European Patent Office**

**Office européen des brevets**

(11) Numéro de publication : **0 269 481 B1**

(12) # FASCICULE DE BREVET EUROPEEN

(45) Date de publication du fascicule du brevet :
**05.06.91 Bulletin 91/23**

(51) Int. Cl.$^5$ : **H03M 5/14**, H04L 7/04,
// H04L25/49

(21) Numéro de dépôt : **87402371.6**

(22) Date de dépôt : **22.10.87**

(54) **Procédé et dispositif de transmission de données numériques.**

(30) Priorité : **30.10.86 FR 8615134**

(43) Date de publication de la demande :
**01.06.88 Bulletin 88/22**

(45) Mention de la délivrance du brevet :
**05.06.91 Bulletin 91/23**

(84) Etats contractants désignés :
**BE CH DE ES FR GB IT LI NL SE**

(56) Documents cités :
**EP-A- 0 053 958**
**EP-A- 0 177 950**
**WO-A-85/01402**
**FR-A- 2 469 046**
**GB-A- 2 105 152**
**US-A- 4 146 909**

(56) Documents cités :
**PROCEEDINGS OF SPIE - THE INTERNATIO-
NAL SOCIETY FOR OPTICAL ENGINEERING,
Arlington, Virginia, 8-9 juin 1983, vol. 421,
"Optical disks systems and applications",
pages 118-127, SPIE, Washington, US; P.C.
HESS et al.: "Implementation of the 3 (1,7)
code for improved packing density on optical
disk recorders"
IBM TECHNICAL DISCLOSURE BULLETIN,
vol. 11, no. 11, avril 1969, page 1570, New York,
US; R.A. DONNAN: "Transmission synchronizing method"
PATENT ABSTRACTS OF JAPAN, vol. 7, no.
292 (E-219)[1437], 27 décembre 1983; & JP-
A-58 168 347 (MITSUBISHI DENKI K.K.) 04-
10-1983**

(73) Titulaire : **BULL S.A.**
**121, Avenue de Malakoff**
**F-75116 Paris (FR)**

(72) Inventeur : **Bacou, Claude**
**30 résidence du Bois du Four**
**F-Neauphle Le Chateau (FR)**
Inventeur : **Cabrol, Christian**
**68 rue Voltaire**
**F-78370 Plaisir (FR)**
Inventeur : **Oisel, André**
**5, Les Nouveaux Horizons**
**F-Elancourt (FR)**
Inventeur : **Baptiste, René**
**50, avenue Cressac**
**F-Elancourt Maurepas (FR)**

EP 0 269 481 B1

## Description

L'invention se situe dans le domaine des transmissions de données numériques et concerne les techniques de codage avant émission et décodage après réception de signaux transmis en série par une ligne de transmission, ces signaux étant autorythmés.

L'invention peut aussi s'appliquer au domaine de l'enregistrement.

L'invention a trait plus particulièrement aux procédés et dispositifs de transmission du type indiqué précédemment et qui permettent un débit de transmission élevé, à grande distance, tout en apportant une sécurité exceptionnelle dans les échanges d'informations.

L'invention peut être utilisée par exemple dans les systèmes informatiques distribués, les réseaux locaux ou les réseaux de CAO (Conception Assistée par Ordinateur).

Nous savons qu'un système de transmission du type concerné par l'invention est constitué par une pluralité d'émetteurs et de récepteurs reliés entre eux par un canal physique. Aussi, lorsqu'on veut augmenter le débit des informations échangées, on est confronté essentiellement à deux types de limitations : la capacité de transmission du canal physique d'une part et la vitesse de traitement des circuits d'interfaces des émetteurs et des récepteurs d'autre part.

Les canaux de transmission utilisent le plus couramment des lignes bifilaires, des câbles coaxiaux ou des liaisons par fibres optiques. La capacité de transmission la plus élevée est actuellement obtenue par l'utilisation des fibres optiques qui permettent des débits de l'ordre d'un gigabit par seconde. Ces performances vont au-delà de celles des circuits d'interface actuels et les progrès à accomplir se situent surtout au niveau de ces circuits. La vitesse des circuits d'interface dépend d'abord de leur fréquence maximale de fonctionnement donc de la technologie employée. Rappelons que les circuits en technologie CMOS peuvent travailler à une fréquence de l'ordre de 20 MHz, les circuits en technologie ECL à une fréquence de l'ordre de 200 MHz et les circuits en technologie arséniure de gallium actuelle à une fréquence de l'ordre de 700 MHz. Ces fréquences de fonctionnement vont donc imposer une première limitation des débits envisageables.

La performance en débit d'un système de transmission ne dépend pas seulement de la fréquence de fonctionnnement des circuits : le débit d'informations utiles et la portée maximum de la transmission s'accroissent lorsque le signal transmis est "autorythmé" (c'est à dire qu'on peut en extraire un signal d'horloge ayant, avec le signal reçu, une relation de phase déterminée). Cette propriété dispense de transmettre l'information et le signal d'horloge dans deux canaux séparés, avec les limitations associées aux difficultés de contrôle du déphasage entre les deux canaux. Pour que l'extraction du signal d'horloge soit possible on code les données utiles avant émission, de telle sorte que la fréquence des transitions dans le signal codé reste supérieure au seuil d'entretien du circuit extracteur (qui peut être un filtre ou une boucle d'asservissement de phase). Le code utilisé, appelé code de modulation, introduit une redondance, si bien que le débit d'informations codées est supérieur au débit d'informations utiles, l'écart dépendant du taux de codage (en anglais coding rate). Ainsi, pour une technologie donnée, le débit maximal de données utiles sera fonction du code de modulation utilisé. La redondance, dont la nécessité apparaît ici, permet en outre de prendre en compte d'autres contraintes que l'on impose au code pour faciliter sa mise en oeuvre, et qui seront indiquées par la suite.

Enfin, si les circuits de transcodage opèrent en parallèle sur des mots de M bits, et non en série sur des bits, une même technologie permet d'atteindre, pour cette fonction, un débit M fois supérieur. Le code de modulation est alors appelé code de groupe. Les systèmes informatiques traitant habituellement des données constituées par un nombre de bits qui est une puissance de 2, les codes de groupe sont construits sur des valeurs de M puissances de 2. Les codes Manchester et de Miller sont des exemples classiques de codes série, dont le taux de codage est de 0,5 (2 bits de code pour 1 bit de donnée). Les circuits de transcodage associés travaillent à une fréquence d'horloge double du débit des données binaires utiles. Par contre, pour le procédé de codage appelé 8B/10B qui, à partir de mots de données utiles de 8 bits en parallèle, génère des mots de code de 10 bits en parallèle, transmis ensuite en série, les circuits de transcodage en parallèle travaillent à une fréquence d'horloge égale à un huitième du débit utile, les seuls circuits de conversion parallèle-série et série-parallèle utilisant une fréquence d'horloge égale à 1,25 fois le débit utile puisque le taux de codage est de 0,8.

Un autre paramètre important influenant les performances des transmissions en série est la plage de variation des interfronts, c'est-à-dire des intervalles de temps séparant deux transitions du signal transmis. La valeur maximale de cet intervalle de temps doit en effet être limitée pour permettre l'extraction du signal d'horloge à partir des seules transitions du signal reçu. Par ailleurs, la plage de variation, qui est définie relativement à la période T de l'horloge du circuit d'extrémité de l'émetteur, détermine le spectre de fréquence des signaux transmis. Par conséquent, ce paramètre conditionne les performances des circuits d'extrémité des récepteurs, tels que transducteur optoélectronique, amplificateur, circuit de régénération du signal d'horloge. Par exemple, dans le cas où le codage est du type parallèle, les bits d'un mot de code sont généralement transmis en série avec une modulation du type NRZ (Non Retour à Zéro). Ainsi les variations de l'intervalle de temps entre deux transitions sont directement fonction des mots de code utilisés, c'est-à-dire des successions de "0" logiques ou "1" logiques apparaissant dans un mot de code. Il conviendra donc de sélectionner les mots de code en tenant compte des intervalles de temps entre deux transitions qu'ils génèrent.

Les contraintes de bande passante mentionnées précédemment doivent être complétées pour tenir compte des considérations suivantes : dans un canal de transmission fonctionnant en bande de base, et où le traitement du signal se résume à une détection de seuil comme c'est généralement le cas, l'information transmise est constituée par le nombre et la position des transitions du signal codé relativement au signal d'horloge qui lui est associé. Les distorsions de phase, qui affectent cette position relative, peuvent donc être sources d'erreurs.

Le signal transmis subit une déformation à caractère aléatoire due au bruit, et une déformation systématique liée à la bande passante du canal. Aux débits élevés qui nous intéressent la bande passante du canal doit être très étendue du côté des fréquences hautes. On la limite du côté des fréquences basses pour réduire le bruit et faciliter la réalisation des transducteurs. Il est alors important que le signal codé ne souffre pas de cette limitation : son spectre doit être dépourvu de composantes très basses fréquences, et le signal codé doit notamment avoir une valeur moyenne constante. Lorsqu'on a affaire à un canal optique utilisant un émetteur à diode laser et/ou un récepteur comportant un contrôle automatique de gain, il est fréquent que la puissance lumineuse émise et le niveau de signal reçu soient contrôlés par des dispositifs d'asservissement qui mesurent la valeur moyenne du signal codé et la maintiennent constante. Ces dispositifs ne fonctionnent correctement que lorsque le procédé de modulation utilisé fournit un signal codé dont la valeur moyenne ne dépend pas de l'information à coder : les codes jouissant de cette propriété sont dits équilibrés en courant continu (en anglais: DC balanced).

Plus précisément, pour qu'un code de modulation soit équilibré en courant continu il faut que l'intégrale par rapport au temps d'un signal transmis soit limitée, quels que soient la nature et la durée du message transmis. Pour mesurer cette propriété du code, il est commode de définir la "charge" d'un mot ou d'un message. Dans le cas d'une modulation NRZ, la charge est définie de la façon suivante : on attribue respectivement les coefficients +1 et −1 aux éléments binaires "1" et "0". La charge est alors définie comme la somme algébrique de ces coefficients pour tous les bits du mot ou du message ou encore comme la différence entre le nombre de "1" et le nombre de "0" constituant le mot ou le message. La charge doit rester comprise entre deux limites finies.

Les données utiles sont transmises sous forme de mots de code concaténés et constitués en trames. Le protocole du réseau ajoute généralement, en fin de trame, des mots de code supplémentaires constituant une "clé". Cette clé permet de détecter les erreurs de transmission les plus fréquentes lorsque la trame ne dépasse pas une certaine longueur. Le décodage, la détection d'erreurs et l'exploitation de la trame exigent que le récepteur localise correctement les frontières de mots et les frontières de trames. Il faut pour cela que l'émetteur ponctue le flot de données utiles au moyen d'indicateurs (en anglais : flags) nécessaires à la synchronisation du récepteur. Ces indicateurs sont par exemple le "jeton" (en anglais : token) conférant à la station qui l'a reçu le droit d'accès au canal, et les délimiteurs de trames, l'indicateur de début de trame synchronisant l'horloge mot du récepteur. Dans toutes les situations de phase de son horloge mot relativement au signal reçu, le récepteur doit donc distinguer les données des indicateurs, et il doit distinguer les indicateurs entre eux. Très généralement la détection d'erreurs s'applique aux données transmises et non aux indicateurs : ceux-ci étant gérés localement par le canal, le dispositif de surveillance du réseau ne perçoit les anomalies qui les affectent qu'indirectement, au terme d'une temporisation (disparition du jeton) ou d'un traitement logiciel complexe (perte d'une trame, duplication du jeton). Ce délai de détection nuit à la qualité du service, notamment si le réseau sert des applications temps réel. Dans les réseaux en anneau où l'information est transmise dans une succession de liaisons point à point, chaque station devant régénérer le signal reçu puis l'émettre vers la station suivante. Chaque trame parcourt tout l'anneau et revient à son origine pour vérification : la probabilité d'erreur relative à une trame augmente avec le nombre de stations présentes sur l'anneau. Dans un tel dispositif il est donc souhaitable que les défauts les plus fréquents (erreurs simples, inversion d'un bit) soient détectés immédiatement et signalés par le récepteur, même lorsqu'ils affectent un indicateur.

Certains des problèmes soulevés dans l'exposé précédent sont évoqués dans le brevet US 4,486,739 du 4 décembre 1984 et dans la publication "IBM Journal of Research and Development", Vol. 27, N° 5, septembre 1983, pages 440 à 451 dans un article intitulé "A DC balanced, partitioned-block, 8B/10B transmission code". Toutefois les codes décrits dans cet article n'offrent pas les garanties nécessaires pour la détection des indicateurs, notamment lorsque l'horloge mot du récepteur n'est plus, ou pas encore, synchronisée sur le signal reçu : un seul indicateur est défini comme ayant une distance de Hamming au moins égale à 2 par rapport à tout mot de code. Il a une distance inférieure à 2 par rapport à des séquences codées associant des segments de mots concaténés. Sachant que l'indicateur est utilisé pour synchroniser l'horloge mot du récepteur, on conçoit l'insuffisance de la propriété : une erreur simple suffit à transformer une donnée en indicateur ou un

3

EP 0 269 481 B1

indicateur en donnée, sans que le décodeur puisse détecter l'erreur.

De même la demande de brevet européen EP-A-177950 décrit un exemple de code 8B/10B où chaque mot de code possède les propriétés suivantes :

- il ne contient pas plus de quatre "1" logiques ou quatre"0" logiques consécutifs ;
- il ne commence ni ne se termine par trois "1" logiques ou trois "0" logiques consécutifs ;
- sa "charge", c'est-à-dire la différence algébrique entre le nombre de "1" logiques et le nombre de "0" logiques qui le constituent est au plus égale à 2 en valeur absolue.

Cependant cette demande ne traite aucunement le cas particulier des indicateurs.

La demande de brevet européen EP-A-53958 concerne un exemple de code 8B/9B tel que l'intervalle de temps entre deux transitions d'un message est compris entre 1T et 6T (T = période d'horloge bit). De plus, chaque mot de code ne commence ni ne se termine par quatre éléments binaires ou plus consécutifs identiques. Ce document mentionne également le cas de mots de synchronisation ayant la propriété de ne jamais se retrouver en plaçant bout à bout deux mots de code quelconques. Selon cet exemple, les mots de synchronisation ont une charge égale à 5 en valeur absolue. Ce code présente l'inconvénient qu'une erreur d'un seul bit dans un message peut faire apparaître un profil identique à un mot de synchronisation.

L'invention a notamment pour but d'éviter ces inconvénients et propose un procédé de codage qui permet une meilleure sécurité tout en répondant au mieux à l'ensemble des contraintes mentionnées précédemment. Le procédé selon l'invention est également conçu pour faciliter sa mise en oeuvre. Aussi l'invention concerne également un dispositif d'émission permettant une mise en oeuvre adaptée au procédé.

Plus précisément l'invention a pour objet un procédé de transmission de données numériques selon lequel chaque mot de donnée comprenant un nombre M de bits est codé par un mot de code associé comprenant N bits, N étant supérieur à M, chaque mot de code étant destiné à être transmis en série, une succession de mots de code formant une trame ou un message, ledit message étant accompagné par au moins un indicateur transmis en série, chacun desdits mots de code ayant les propriétés suivantes :

- il ne contient pas plus de quatre "1" logiques ou quatre "0" logiques consécutifs ;
- il ne commence ni ne se termine par plus de deux "1" logiques ou plus de deux "0" logiques consécutifs;
- sa "charge", c'est-à-dire la différence algébrique entre le nombre de "1" logiques et le nombre de "0" logiques qui le constituent est au plus égale à 2 en valeur absolue. Ledit procédé de transmission est caractérisé en ce que tout indicateur comporte un nombre de bits égal à N ou un multiple de N et a les propriétés suivantes :

- il ne contient pas plus de quatre "1" logiques ou quatre "0" logiques consécutifs ;
- il ne commence ni ne se termine par plus de deux "1" logiques ou plus de deux "0" logiques consécutifs;
- entre un indicateur et toute séquence codée de même longueur extraite d'un message quelconque, la distance de Hamming est au moins égale à 2.

L'invention a également pour objet un dispositif d'émission pour système de transmission de données numériques, comprenant un dispositif de codage recevant des mots de donnée comprenant M bits en parallèle et délivrant des mots de code comprenant N bits en parallèle, N étant supérieur à M, à un dispositif de conversion parallèle-série, une horloge locale reliée à un dispositif de commande fournissant des signaux de commande et de synchronisation auxdits dispositifs de codage et de conversion de façon à émettre en série des successions d'indicateurs et de mots de code formant des messages, ledit dispositif de codage comprenant des moyens pour générer en fonction de chaque mot de donnée un mot de code ayant les propriétés suivantes:

- il ne contient pas plus de quatre "1" logiques ou quatre "0" logiques consécutifs,
- il ne commence ni ne se termine par plus de deux "1" logiques ou plus de deux "0" logiques consécutifs, chaque mot de code ayant une charge au plus égale à 1 en valeur absolue si N est impair ou à 2 en valeur absolue si N est pair, ledit dispositif d'émission étant caractérisé en ce que ledit dispositif de codage comprend en outre des moyens pour générer en fonction de signaux de commande un indicateur ayant les propriétés suivantes :

- il ne contient pas plus de quatre "1" logiques ou quatre "0" logiques consécutifs,
- il ne commence ni ne se termine par plus de deux "1" logiques ou plus de deux "0" logiques consécutifs,
- la distance de Hamming entre un indicateur et toute séquence extraite d'un message quelconque et constituée par autant de bits consécutifs que l'indicateur est au moins égale à deux, ledit dispositif de codage (1) pouvant délivrer soit un indicateur soit une fraction d'indicateur selon que l'indicateur comprend N bit ou un multiple de N bits.

D'autres caractéristiques et détails de réalisation apparaîtront dans les modes de réalisation préférentiels décrits qui vont suivre.

- La figure 1 représente schématiquement des dispositifs d'émission et de réception selon l'invention.
- La figure 2 représente plus en détail un dispositif d'émission selon l'invention.
- La figure 3 représente plus en détail un dispositif de réception selon l'invention.

– Les figures 4A et 4B montrent l'organisation et une réalisation d'un dispositif de codage selon l'invention.
– Les figures 5A et 5B montrent l'organisation et une réalisation d'un dispositif de décodage selon l'invention.
– La figure 6 représente une réalisation d'un dispositif de commande d'émission selon l'invention.
– Les figures 7, 8, 9, 10 et 11 représentent les éléments d'un mode de réalisation du dispositif de réception selon l'invention.
– La figure 12 représente des chronogrammes permettant d'expliquer le fonctionnement du dispositif de réception.

De façon classique, un procédé de transmission est constitué par un procédé d'émission associé à un procédé de réception conditionné par le procédé d'émission.

Une première caractéristique importante d'un procédé de transmission est le procédé de codage des mots de donnée à transmettre qui doit faciliter le décodage à la réception. Une autre caractéristique importante est le procédé de génération d'indicateurs liés au protocole de transmission, qui doit favoriser la détection de ces indicateurs à la réception. Comme nous allons le voir dans l'exposé qui va suivre, le procédé de transmission selon l'invention concerne en particulier ces procédés de codage et de génération d'indicateurs, notamment l'utilisation de mots de code et d'indicateurs ayant des propriétés étroitement liées à des contraintes de performance et de fiabilité de la transmission. Afin de mieux faire ressortir ces avantages procurés par le procédé de transmission selon l'invention, il convient de donner quelques indications sur la façon de le mettre en oeuvre.

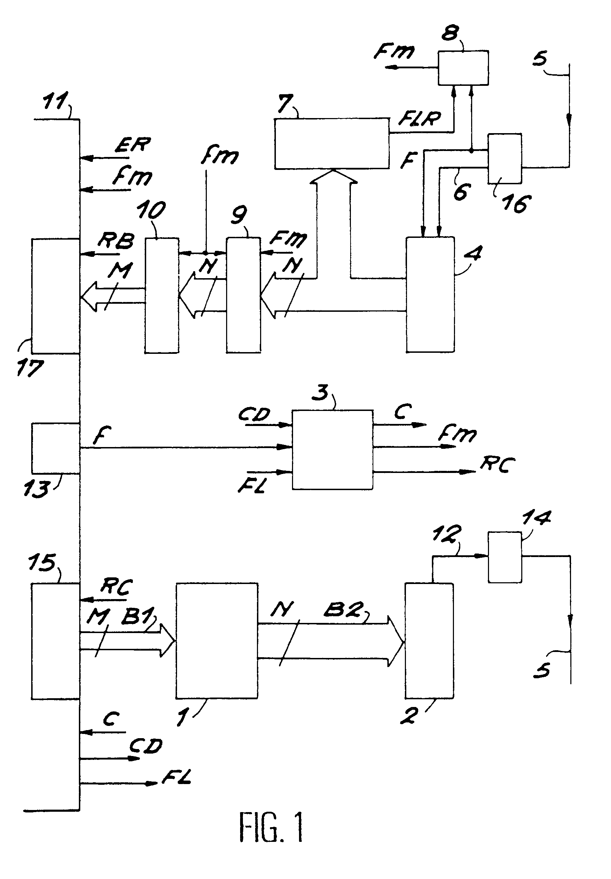

La figure 1 montre de façon schématique les éléments essentiels qui constituent les circuits de codage et de décodage utilisés dans un terminal d'un réseau. Les données à coder apparaissent sur le bus B1 qui est relié au circuit de codage 1. Le bus B1 comporte un nombre M de lignes et le circuit de codage délivre à sa sortie N bits en parallèle qui sont transmis par un bus B2 à un circuit 2 de conversion parallèle-série, dont la sortie 12 est reliée au canal de transmission 5 par l'intermédiaire d'un transducteur 14. Le circuit comporte également une horloge 13 et un dispositif de commande et de séquencement 3 qui pilote en synchronisme le convertisseur parallèle-série 2 et le circuit de codage 1. Si on appelle f la fréquence d'horloge à laquelle sont transmises en série les informations codées vers le canal de transmission 5, le convertisseur parallèle-série devra donc travailler à cette fréquence f tandis que le circuit de codage 1 devra travailler à la fréquence f/N.

La partie réception comprend un transducteur-extracteur d'horloge 16 qui reçoit en série du canal 5 les informations codées ; il délivre deux signaux au convertisseur série-parallèle 4 : le signal d'horloge bit F, et sur sa sortie série 6 les informations codées synchrones de l'horloge F. Le convertisseur 4 est relié par sa sortie parallèle à deux dispositifs : un détecteur d'indicateurs 7, et un tampon 9 auquel il délivre des mots codés de N bits. Un dispositif de commande et de séquencement 8 reçoit du transducteur 16 le signal d'horloge bit F, et du détecteur 7 le signal FLR témoin de la réception d'un indicateur de synchronisation mot. Le dispositif 8 délivre en sortie un signal d'horloge mot reçue Fm, de fréquence F/N, qui rythme les transferts entre le convertisseur 4 et le tampon 9. Seuls les dispositifs de réception mentionnés ci-dessus dépendent, pour leur synchronisation, de l'horloge bit reçue F et de l'horloge mot reçue qui s'en déduit.

Le tampon 9 délivre à sa sortie des mots codés de N bits en parallèle à un circuit de décodage 10. Le circuit de décodage délivre à sa sortie des mots de donnée de M bits en parallèle associés, selon le code choisi, aux mots de N bits reçus. La partie réception, lorsqu'elle détecte une erreur de transmission ou un mauvais fonctionnement quelconque, l'indique à la station 11 en affirmant le signal ER. L'horloge mot locale fm régit les échanges entre la sortie du tampon 9, le décodeur 10 et la station 11.

Dans la partie réception le convertisseur série-parallèle travaille donc à la fréquence de F, tandis que le tampon 9 et le circuit de décodage 10 travaillent seulement à une fréquence N fois inférieure. Ainsi les circuits les plus complexes (tampon, codeur, décodeur) peuvent être réalisés avec une technologie moins rapide que celle réservée au transducteur, au convertisseur série-parallèle et au détecteur d'indicateurs.

Nous allons maintenant décrire en détail la méthode pour obtenir les mots de code et les indicateurs utilisés dans le procédé de transmission qui a été défini précédemment.

Compte tenu de contraintes liées aux applications envisagées, le choix de M et de N n'est pas arbitraire : si le terminal travaille sur des mots de 16 bits, on pourra choisir M = 16 ou même un sous-multiple de 16. Si l'on prend M = 8, les mots de donnée du terminal devront être multiplexés en deux groupes de 8 bits avant codage. Ceci a évidemment l'inconvénient de ralentir le traitement du codage. En contre partie le circuit de codage sera simplifié. Sur la base de cet exemple, nous voyons donc que le choix de M constituera un compromis entre la performance du codage parallèle et l'encombrement de sa réalisation.

Lorsque M aura été choisi, définissant $2^M$ combinaisons possibles de M bits, donc $2^M$ mots de donnée à coder, il conviendra de déterminer N pour qu'il existe au moins $2^M$ mots de code de N bits respectant les contraintes technologiques liées au canal de transmission.

La première contrainte, déjà évoquée précédemment, concerne la plage de variation des interfronts des signaux transmis. Le procédé selon l'invention impose que tout interfront soit compris entre 1 T et 4 T, T étant la période de la transmission série. Il faut doncexclure comme mots de code tous ceux qui comportent plus de quatre "1" logiques ou quatre "0" logiques consécutifs. D'autre part, il faut qu'un message quelconque vérifie également cette contrainte. Il conviendra donc que la concaténation de deux mots de code quelconques ne puisse jamais faire apparaître plus de quatre "1" logiques ou quatre "0" logiques consécutifs. Dans ce but, il suffira d'écarter l'utilisation des mots de code qui commencent ou qui se terminent par plus de deux "0" ou plus de deux "1" logiques consécutifs. Si cette condition n'était pas réalisée, il faudrait alors prévoir une logique d'enchaînement de mots, ce qui entraînerait évidemment une complication au niveau de la commande et augmenterait la propagation des erreurs : ici, l'indépendance des mots de code concatenés fait que, si l'un d'entre eux est affecté par une erreur de transmission, cette erreur restera confinée dans un mot de donnée de M bits après décodage.

En plus de la contrainte précédente, les mots de code sélectionnés doivent satisfaire à une deuxième contrainte liée à la charge. Le problème général à résoudre sera donc de déterminer des mots de code et des enchaînements de mots qui limitent la charge cumulée d'un message quelconque.

Une première démarche pour résoudre ce problème consistera à sélectionner en priorité des mots de code ayant une charge minimale.

Dans le cas où N est un nombre pair, il existe des mots de code qui ont une charge nulle. Il s'agit de tous les mots de code possédant autant de "0" logiques que de "1" logiques. Ces mots de code à charge nulle seront donc les plus intéressants à conserver pour l'élaboration d'un système de codage. Toutefois, selon la valeur de N choisie et compte tenu des contraintes imposées, il sera possible ou non de trouver autant de mots de code de charge nulle que de mots de donnée à coder. Ainsi, pour le code 8B/10B, il y a 256 mots de donnée différents à coder. Les mots de code seront à choisir parmi les 1024 combinaisons possibles de 10 bits. Mais, si on ne conserve que les mots qui satisfont les contraintes d'interfront et d'extrémités, on ne trouve que 180 mots de code possibles qui ont une charge nulle, ce qui est insuffisant pour coder les 256 mots de donnée. On sera donc obligé d'accepter des mots de code ayant une charge non nulle. Ces mots de code de charge non nulle de valeur absolue minimale sont ceux qui possèdent quatre "1" logiques et six "0" logiques ou quatre "0" logiques et six "1" logiques. Chacun de ces mots aura une charge égale à 2 en valeur absolue. Compte tenu des contraintes choisies il existe 124 mots à charge +2, et leurs 124 compléments à charge −2.

Si l'on utilise les mots de code sans précaution, il pourra se produire qu'un message soit constitué par une succession de mots de code qui ont tous une charge positive. Ainsi, la charge cumulée du message pourrait croître sans limitation. Il faudra donc prévoir une méthode permettant de limiter la charge cumulée.

Pour cela, on considère que l'ensemble de tous les mots de donnée possibles est divisé en deux sous-ensembles : le premier sous-ensemble comprend les mots de donnée qui sont associés de façon biunivoque à un mot de code de charge nulle, le deuxième sous-ensemble étant constitué par les mots de donnée restants qui sont associés chacun à deux mots de code de charges opposées non nulles. Pour assurer qu'un message quelconque ait une charge limitée, il conviendra de prévoir une gestion de charge. Cette gestion consistera d'abord à mémoriser la charge du dernier mot de code chargé émis. Ensuite, dès qu'apparaît un mot de donnée à coder correspondant à un mot de code de charge non nulle, on sélectionnera celui des mots de code ayant une charge opposée à la charge mémorisée. Une telle gestion est facile à réaliser comme nous le verrons ultérieurement dans la description du mode de réalisation.

Dans le cas du code 8B/10B, il existe donc 180 mots de code de charge nulle répondant également au critère d'interfronts inférieurs ou égaux à 4T. Il existe en outre 124 mots de code ayant une charge égale à +2 et 124 mots de code, compléments des précédents, ayant une charge égale à −2. Nous avons donc à notre disposition un total de 304 mots de code différents destinés à coder les 256 mots de données possibles, ce qui paraît suffisant. Les deux mots de code chargés associés au même mot de donnée peuvent par exemple être complémentaires l'un de l'autre.

Une méthode analogue peut être utilisée dans le cas où N est impair mais dans ce cas, il n'existe aucun mot de code de charge nulle.

Pour réaliser un procédé de transmission, il faut également choisir des indicateurs. Comme déjà mentionné en référence à la figure 1, le procédé de codage exige la présence d'une horloge de mot. Cette horloge de mot doit exister aussi bien au niveau du circuit de codage qu'au niveau du circuit de décodage. Pour faciliter la synchronisation surtout au niveau du circuit de décodage, il vaut mieux choisir des indicateurs dont la longueur soit multiple de celle des mots de code. D'autre part, ces indicateurs devront satisfaire également aux deux critères précédents.

Enfin, il est important que les récepteurs soient capables de détecter avec sûreté ces indicateurs. Dans ce but, selon une caractéristique importante de l'invention, une contrainte supplémentaire est imposée à ces indicateurs. Cette contrainte impose que tout indicateur soit à une distance de Hamming (ou distance logique) au moins égale à 2 par rapport à toute séquence extraite d'un message quelconque et constituée par autant de bits consécutifs qu'en comporte l'indicateur. Ainsi, grâce à cette condition supplémentaire, on est sûr qu'une erreur d'un bit pourra être détectée par le décodeur si elle affecte un indicateur ; elle ne pourra ni transformer un indicateur en un autre indicateur, ni transformer une séquence de donnée en indicateur.

La recherche d'indicateurs satisfaisant à toutes les contraintes précédentes n'aboutit pas forcément pour un code quelconque. Cependant il est possible de trouver une solution si l'on accorde aux indicateurs une longueur suffisante. Pour illustrer cette possibilité, nous allons indiquer en détail les résultats obtenus dans le cas du code 8B/10B. Il est clair cependant que l'on peut généraliser à un code quelconque la méthode de recherche des indicateurs qui va être exposée dans ce qui suit.

Pour des raisons de simplicité, il convient de rechercher d'abord l'existence d'indicateurs de même longueur qu'un mot de code. Comme nous l'avons vu précédemment, il existe 304 mots de code possibles, appelés par la suite "mots de code candidats". Les indicateurs devront donc être recherchés parmi ceux-ci. La recherche peut être faite systématiquement de la façon suivante. Parmi les 304 mots de code candidats, on en choisit un, que l'on définira comme un "indicateur candidat". On considère ensuite l'ensemble des mots de code restant et l'on forme tous les couples possibles de mots de code extraits de cet ensemble en respectant la règle de l'alternance des charges. On considère alors les mots formés par concaténation des deux mots de chacun de ces couples et on compare l'indicateur candidat avec tout ensemble de bits consécutifs de même longueur extrait de ce couple. Si cette comparaison révèle que la distance logique entre l'indicateur candidat et au moins une séquence est égale à 0 ou à 1, le couple testé ne devra jamais apparaître dans un message. Pour cela, il faudra nécessairement qu'au moins un des mots de code candidats constituant ce couple ne figure pas dans l'ensemble des mots de code retenus. Lorsqu'on a répété la même opération pour tous les couples de mots de code, il faut éliminer le minimum de mots de code candidats de façon à rendre impossible la présence des couples identifiés lors du test précédent. Encore faudra-t-il qu'il reste un nombre suffisant de mots de code. L'opération peut être recommencée en prenant comme indicateur candidat chacun des mots de code de l'ensemble considéré.

Dans le cas du code 8B/10B, il a été impossible de trouver un indicateur de longueur 10 bits répondant à tous les critères exigés, mais cela ne préjuge pas du résultat dans le cas d'autres codes comprenant des mots plus longs.

Si, comme dans l'exemple précédent, on ne trouve pas d'indicateur ayant la même longueur qu'un mot de code, il conviendra alors de rechercher des indicateurs ayant une longueur égale à deux mots de code. Pour le code 8B/10B nous rechercherons donc des indicateurs comprenant 20 bits.

La méthode de recherche des indicateurs sera la suivante :

(a) Comme précédemment on a établi la liste de mots de code candidats comprenant 10 bits.

(b) On établit ensuite une liste des "indicateurs candidats" obtenue par la sélection des mots de 20 bits qui satisfont aux conditions suivantes :

– ils sont formés de deux mots de 10 bits, m1 et m2, concaténés dans cet ordre ;

– m1 et m2 ne contiennent pas plus de quatre "1" logiques ou quatre "0" logiques ques consécutifs ;

– ni le début de m1 ni la fin de m2 ne contiennent plus de deux "1" logiques ou plus de deux "0" logiques consécutifs ;

– la fin de m1 et le début de m2 contiennent l'une et l'autre plus de deux "1" logiques ou plus de deux "0" logiques consécutifs.

(c) On teste chaque indicateur candidat, en déterminant la distance de Hamming entre chacun des mots de code candidats et toutes les séquences de 10 bits consécutifs que l'on peut extraire de l'indicateur candidat testé.

(d) Si la distance de Hamming entre un mot de code candidat testé et chacune desdites séquences extraite de l'indicateur candidat est supérieure ou égale à 2, le mot de code candidat est admis dans le code.

(e) S'il existe au moins une séquence à une distance de Hamming égale à 1, on considère pour chacune de ces séquences, le premier et le second ensemble de bits constitués par les premiers, respectivement, derniers bits de l'indicateur candidat n'appartenant pas à la séquence et on forme une première liste comprenant les mots de code candidats qui se terminent par le premier ensemble de bits et une seconde liste comprenant ceux qui commencent par le second ensemble de bits. Si l'une des deux listes est vide, le mot de code testé est conservé ; si aucune liste n'est vide, on forme, en respectant la règle de l'alternance des charges, tous les triplets possibles constitués par un mot de la première liste, le mot de code testé et un mot de la seconde liste.

(f) S'il existe au moins une séquence à une distance de Hamming nulle, on considère, pour chacune de ces séquences, le premier et le second ensemble de bits constitués par les premiers, respectivement, derniers bits de l'indicateur candidat n'appartenant pas à la séquence et on forme une première liste comprenant les mots de code candidats qui se terminent exactement ou à un bit prés par le premier ensemble de bits et une seconde liste comprenant ceux qui commencent exactement ou à un bit près, par le second ensemble de bits.

On forme, en respectant la règle de l'alternance des charges, tous les triplets possibles constitués par un mot de la première liste, le mot de code testé et un mot de la seconde liste en excluant tous les triplets comprenant deux mots à distance 1, chacun emprunté à une des listes ci-dessus.

Si aucun triplet ne peut être formé, le mot de code testé est conservé.

(g) Après avoir effectué les opérations (d), (e) et (f) pour tous les mots de code candidats, on considère l'ensemble des triplets qui ont été formés et on supprime au moins un des mots de code candidats apparaissant dans chacun de ces triplets de façon à ce qu'il n'existe plus aucun triplet.

Si le nombre de mots de code restant après l'élimination mentionnée précédemment est supérieur à $2^M$, l'indicateur candidat peut être utilisé comme indicateur à condition d'être associé aux mots de code que l'on a conservés. Si le nombre de mots de code est insuffisant, il faut tester un autre indicateur pris parmi la liste des indicateurs candidats en effectuant à nouveau les opérations (c) à (g) précédentes.

Un exemple de démarche permettant de choisir un code et un ensemble d'indicateurs compatibles par introductions successives de contraintes, illustrera les possibilités offertes par la méthode décrite ci-dessus. Le choix des contraintes, qui dépend entre autres considérations du protocole de transmission retenu, des performances souhaitées, des technologies accessibles, doit être laissé à l'homme du métier. On peut imposer que les indicateurs soient composés de deux mots de 10 bits ayant l'un et l'autre une charge nulle. Cette contrainte, ajoutée à celles indiquées en (b), conduit à définir un ensemble de 338 indicateurs candidats. La méthode précédente appliquée à ces candidats permet cette fois de démontrer que chacun, pouvant être associé à plus de 256 des 304 mots de code candidats, est un indicateur possible. On ajoute alors une contrainte portant sur les mots de code candidats la gestion de charge est telle que, dans un message fait de mots de code concaténés, la charge cumulée, mesurée aux frontières entre mots, ne puisse prendre que deux valeurs = 0 et +2. Si l'on code un des 180 mots dont la charge propre est nulle, alors que la charge initiale est nulle, la charge mesurée cette fois à la fin de chaque bit codé oscille autour de la valeur 0 ; elle est généralement limitée à −2 mais 9 des 180 mots lui font atteindre la valeur −3. De même si la charge initiale est +2, la charge instantanée est généralement limitée à +4 mais 9 des 180 mots lui font atteindre la valeur +5. Si, de l'ensemble des 304 mots de code candidats, on retire les 18 mots singuliers, il reste 162 mots à charge nulle et 124 couples de mots complémentaires à charge ± 2. Parmi les 338 indicateurs candidats, 222 sont encore compatibles à plus de 256 mots de code candidats conservés. Enfin dans tout message codé n'incluant pas d'indicateur, la charge instantanée reste comprise entre +4 et −2 ; on a donc défini un code à 7 niveaux de charge selon la convention généralement utilisée.

On constitue ainsi des ensembles comprenant un indicateur et ses mots de code associés. Pour constituer un code possèdant plusieurs indicateurs, il suffit de trouver plusieurs ensembles compatibles, c'est-à-dire tels qu'ils comprennent au moins autant de mots de code en commun que le nombre de mots de données possibles et tels que la distance de Hamming entre deux indicateurs quelconques soit au moins égale à deux. Dans le cas du code 8B/10B et en limitant à 7 le nombre de niveaux de charge nécessaires au codage des informations, il est possible de trouver jusqu'à six indicateurs de 20 bits de charge nulle, associés à plus de 256 mots de code, chacun des indicateurs étant à une distance de Hamming au moins égale à 2 vis-à-vis de chacun des autres indicateurs.

En respectant la contrainte des 7 niveaux de charge on trouve ainsi 795 codes différents compatibles à 2 indicateurs, et 56 codes différents compatibles à 6 indicateurs.

Pour tout nombre d'indicateurs ne dépassant pas 6 on aura donc le choix entre de nombreuses solutions. On pourra par exemple :
- s'orienter vers des ensembles d'indicateurs compatibles à plus de 256 mots, et utiliser les mots en excès pour assurer le remplissage inter-trames et le codage d'informations booléennes ;
- imposer que la distance logique entre indicateurs soit supérieure à 3, ou 4... ;
- limiter le nombre de niveaux de charge nécessaires au codage des indicateurs dans les trames ;
- choisir un ensemble d'indicateurs tel que la logique nécessaire à leur détection soit minimale ;
- choisir un code tel que, si les fonctions de transcodage sont réalisées en logique combinatoire, cette logique soit optimisée en volume, ou en performance.

Un exemple de code acceptant 4 indicateurs est donné par la table ci-dessous. Dans cette table les indicateurs, le "filler" et les mots de code sont exprimés en valeur décimale, les mots de donnée sont exprimés en valeur héxadécimale dans la colonne D, et les bits.a. à.j. du mot de code sont indiqués en valeur binaire.

TABLE DE CODAGE                 FILLER = 341
INDICATEURS : 385953 - 385986 - 770977 - 771010

_____

| D  | CODE | abicdefjgh | | D  | CODE | abicdefjgh | |
|----|------|------------|-|----|------|------------|-|
| 00 | 171  | 0010101011 | | 1E | 309  | 0100110101 | |
| 01 | 173  | 0010101101 | | 1F | 310  | 0100110110 | |
| 02 | 174  | 0010101110 | | 20 | 313  | 0100111001 | |
| 03 | 179  | 0010110011 | | 21 | 314  | 0100111010 | |
| 04 | 181  | 0010110101 | | 22 | 316  | 0100111100 | |
| 05 | 182  | 0010110110 | | 23 | 331  | 0101001011 | |
| 06 | 185  | 0010111001 | | 24 | 333  | 0101001101 | |
| 07 | 186  | 0010111010 | | 25 | 334  | 0101001110 | |
| 08 | 203  | 0011001011 | | 26 | 339  | 0101010011 | |
| 09 | 205  | 0011001101 | | 27 | 342  | 0101010110 | |
| 0A | 206  | 0011001110 | | 28 | 345  | 0101011001 | |
| 0B | 211  | 0011010011 | | 29 | 346  | 0101011010 | |
| 0C | 213  | 0011010101 | | 2A | 348  | 0101011100 | |
| 0D | 214  | 0011010110 | | 2B | 355  | 0101100011 | |
| 0E | 217  | 0011011001 | | 2C | 357  | 0101100101 | |
| 0F | 218  | 0011011010 | | 2D | 358  | 0101100110 | |
| 10 | 220  | 0011011100 | | 2E | 361  | 0101101001 | |
| 11 | 227  | 0011100011 | | 2F | 362  | 0101101010 | |
| 12 | 229  | 0011100101 | | 30 | 364  | 0101101100 | |
| 13 | 230  | 0011100110 | | 31 | 369  | 0101110001 | |
| 14 | 233  | 0011101001 | | 32 | 650  | 1010001010 | |
| 15 | 234  | 0011101010 | | 33 | 370  | 0101110010 | |
| 16 | 236  | 0011101100 | | 34 | 372  | 0101110100 | |
| 17 | 241  | 0011110001 | | 35 | 395  | 0110001011 | |
| 18 | 242  | 0011110010 | | 36 | 397  | 0110001101 | |
| 19 | 244  | 0011110100 | | 37 | 403  | 0110010011 | |
| 1A | 299  | 0100101011 | | 38 | 405  | 0110010101 | |
| 1B | 301  | 0100101101 | | 39 | 406  | 0110010110 | |
| 1C | 302  | 0100101110 | | 3A | 409  | 0110011001 | |
| 1D | 307  | 0100110011 | | 3B | 410  | 0110011010 | |

| | | | | | |
|---|---|---|---|---|---|
| 3C | 412 | 0110011100 | 60 | 626 | 1001110010 |
| 3D | 419 | 0110100011 | 61 | 628 | 1001110100 |
| 3E | 421 | 0110100101 | 62 | 651 | 1010001011 |
| 3F | 422 | 0110100110 | 63 | 653 | 1010001101 |
| 40 | 428 | 0110101100 | 64 | 659 | 1010010011 |
| 41 | 436 | 0110110100 | 65 | 661 | 1010010101 |
| 42 | 453 | 0111000101 | 66 | 662 | 1010010110 |
| 43 | 454 | 0111000110 | 67 | 665 | 1010011001 |
| 44 | 460 | 0111001100 | 68 | 666 | 1010011010 |
| 45 | 465 | 0111010001 | 69 | 668 | 1010011100 |
| 46 | 468 | 0111010100 | 6A | 675 | 1010100011 |
| 47 | 555 | 1000101011 | 6B | 677 | 1010100101 |
| 48 | 557 | 1000101101 | 6C | 678 | 1010100110 |
| 49 | 558 | 1000101110 | 6D | 684 | 1010101100 |
| 4A | 563 | 1000110011 | 6E | 692 | 1010110100 |
| 4B | 565 | 1000110101 | 6F | 709 | 1011000101 |
| 4C | 566 | 1000110110 | 70 | 710 | 1011000110 |
| 4D | 569 | 1000111001 | 71 | 716 | 1011001100 |
| 4E | 570 | 1000111010 | 72 | 724 | 1011010100 |
| 4F | 587 | 1001001011 | 73 | 781 | 1100001101 |
| 50 | 589 | 1001001101 | 74 | 787 | 1100010011 |
| 51 | 590 | 1001001110 | 75 | 789 | 1100010101 |
| 52 | 595 | 1001010011 | 76 | 790 | 1100010110 |
| 53 | 597 | 1001010101 | 77 | 793 | 1100011001 |
| 54 | 598 | 1001010110 | 78 | 794 | 1100011010 |
| 55 | 601 | 1001011001 | 79 | 796 | 1100011100 |
| 56 | 602 | 1001011010 | 7A | 803 | 1100100011 |
| 57 | 604 | 1001011100 | 7B | 805 | 1100100101 |
| 58 | 611 | 1001100011 | 7C | 806 | 1100100110 |
| 59 | 613 | 1001100101 | 7D | 809 | 1100101001 |
| 5A | 614 | 1001100110 | 7E | 810 | 1100101010 |
| 5B | 617 | 1001101001 | 7F | 812 | 1100101100 |
| 5C | 618 | 1001101010 | 80 | 817 | 1100110001 |
| 5D | 620 | 1001101100 | 81 | 818 | 1100110010 |
| 5E | 625 | 1001110001 | 82 | 820 | 1100110100 |
| 5F | 394 | 0110001010 | 83 | 837 | 1101000101 |

| 84 | 838 | 1101000110 | A8 | 554 | 1000101010 |
| 85 | 841 | 1101001001 | A9 | 212 | 0011010100 |
| 86 | 842 | 1101001010 | AA | 337 | 0101010001 |
| 87 | 844 | 1101001100 | AB | 172 | 0010101100 |
| 88 | 849 | 1101010001 | AC | 330 | 0101001010 |
| 89 | 850 | 1101010010 | AD | 298 | 0100101010 |
| 8A | 852 | 1101010100 | AE | 149 | 0010010101 |
| 8B | 425 | 0110101001 | AF | 593 | 1001010001 |
| 8C | 433 | 0110110001 | B0 | 363 | 0101101011 |
| 8D | 142 | 0010001110 | B1 | 305 | 0100110001 |
| 8E | 457 | 0111001001 | B2 | 198 | 0011000110 |
| 8F | 434 | 0110110010 | B3 | 586 | 1001001010 |
| 90 | 466 | 0111010010 | B4 | 165 | 0010100101 |
| 91 | 652 | 1010001100 | B5 | 722 | 1011010010 |
| 92 | 681 | 1010101001 | B6 | 396 | 0110001100 |
| 93 | 404 | 0110010100 | B7 | 594 | 1001010010 |
| 94 | 713 | 1011001001 | B8 | 389 | 0110000101 |
| 95 | 150 | 0010010110 | B9 | 726 | 1011010110 |
| 96 | 306 | 0100110010 | BA | 426 | 0110101010 |
| 97 | 204 | 0011001100 | BB | 603 | 1001011011 |
| 98 | 438 | 0110110110 | BC | 714 | 1011001010 |
| 99 | 197 | 0011000101 | BD | 458 | 0111001010 |
| 9A | 690 | 1010110010 | BE | 682 | 1010101010 |
| 9B | 141 | 0010001101 | BF | 788 | 1100010100 |
| 9C | 553 | 1000101001 | C0 | 732 | 1011011100 |
| 9D | 685 | 1010101101 | C1 | 163 | 0010100011 |
| 9E | 390 | 0110000110 | C2 | 238 | 0011101110 |
| 9F | 721 | 1011010001 | C3 | 237 | 0011101101 |
| A0 | 166 | 0010100110 | C4 | 610 | 1001100010 |
| A1 | 329 | 0101001001 | C5 | 411 | 0110011011 |
| A2 | 180 | 0010110100 | C6 | 742 | 1011100110 |
| A3 | 562 | 1000110010 | C7 | 153 | 0010011001 |
| A4 | 347 | 0101011011 | C8 | 609 | 1001100001 |
| A5 | 689 | 1010110001 | C9 | 154 | 0010011010 |
| A6 | 561 | 1000110001 | CA | 282 | 0100011010 |
| A7 | 452 | 0111000100 | CB | 228 | 0011100100 |

| | | | | | |
|---|---|---|---|---|---|
| CC | 538 | 1000011010 | E6 | 340 | 0101010100 |
| CD | 356 | 0101100100 | E7 | 139 | 0010001011 |
| CE | 670 | 1010011110 | E8 | 308 | 0100110100 |
| CF | 354 | 0101100010 | E9 | 195 | 0011000011 |
| D0 | 486 | 0111100110 | EA | 201 | 0011001001 |
| D1 | 748 | 1011101100 | EB | 596 | 1001010100 |
| D2 | 147 | 0010010011 | EC | 315 | 0100111011 |
| D3 | 802 | 1100100010 | ED | 813 | 1100101101 |
| D4 | 219 | 0011011011 | EE | 649 | 1010001001 |
| D5 | 476 | 0111011100 | EF | 243 | 0011110011 |
| D6 | 531 | 1000010011 | F0 | 393 | 0110001001 |
| D7 | 658 | 1010010010 | F1 | 821 | 1100110101 |
| D8 | 534 | 1000010110 | F2 | 435 | 0110110011 |
| D9 | 349 | 0101011101 | F3 | 332 | 0101001100 |
| DA | 550 | 1000100110 | F4 | 187 | 0010111011 |
| DB | 657 | 1010010001 | F5 | 582 | 1001000110 |
| DC | 490 | 0111101010 | F6 | 581 | 1001000101 |
| DD | 549 | 1000100101 | F7 | 556 | 1000101100 |
| DE | 730 | 1011011010 | F8 | 697 | 1010111001 |
| DF | 605 | 1001011101 | F9 | 698 | 1010111010 |
| E0 | 729 | 1011011001 | FA | 300 | 0100101100 |
| E1 | 402 | 0110010010 | FB | 845 | 1101001101 |
| E2 | 745 | 1011101001 | FC | 853 | 1101010101 |
| E3 | 401 | 0110010001 | FD | 854 | 1101010110 |
| E4 | 746 | 1011101010 | FE | 739 | 1011100011 |
| E5 | 459 | 0111001011 | FF | 156 | 0010011100 |

Il est inutile de décrire en détail d'autres solutions particulières trouvées par la recherche systématique précédente car il suffit à l'homme du métier de suivre la méthode indiquée. Il est clair que la recherche de solution est grandement facilitée par l'utilisation de moyens informatiques couramment utilisés dans l'industrie actuellement. Parmi les différentes solutions, l'homme du métier sera en mesure de sélectionner celle qui correspond à l'application qu'il traite.

La détermination des mots de code et des indicateurs constitue l'étape essentielle pour définir le procédé de transmission selon l'invention. Le procédé peut ensuite être complété par des caractéristiques supplémentaires.

En particulier, on peut prévoir un multiplexage et un démultiplexage des données du terminal dans le cas où celles-ci sont constituées de mots "utilisateur" de longueur égale à un multiple de la longueur d'un mot de donnée.

Enfin il est habituel de mettre en oeuvre dans le dispositif de transmission un mécanisme de détection d'erreurs permettant, pour chaque trame reçue, d'affirmer avec une faible probabilité d'erreur que les données qu'elle contient ont été (ou n'ont pas été) modifiées par une erreur de transmission. Les procédés de transmission les plus répandus utilisent des codes de modulation série de type Manchester par exemple, où la propagation d'erreur est nulle : une erreur inversant un des bits de l'information codée se traduit après décodage par une erreur inversant un seul bit de donnée.

A ces codes de modulation on associe généralement un code cyclique binaire, pour la détection (éventuellement la correction) des erreurs. Les plus connus de ces codes sont les suivants :

– les codes de Hamming étendus permettant la détection d'une erreur portant sur 1, 2 ou 3 bits ;

– les codes de FIRE permettant de traiter le cas où le signal est entaché d'une erreur portant sur un paquet de bits unique ;

– les codes BCH, généralisation des codes de Hamming, pouvant détecter des erreurs portant sur un nombre de bits isolés supérieur.

Dans le cas de l'invention, le code de modulation opère sur des groupes de M bits, de sorte que la propagation des erreurs est confinée aux frontières de groupes de M bits.

Dans ce cas, il est avantageux d'opter pour des codes détecteurs ou correcteurs d'erreurs, non plus binaires, mais construits sur des symboles de M bits (ou multiples de M bits), sous réserve que les frontières de symboles du code correcteur coïncident avec les frontières de groupes du code de modulation.

Les codes Reed-Solomon appartiennent à cette catégorie. Ils ont en outre l'intérêt de pouvoir traiter (en détection comme en correction) des situations d'erreurs portant sur plusieurs symboles de M bits dispersés à l'intérieur des blocs.

Les codes Reed-Solomon ont en outre l'avantage de pouvoir être implantés en série-parallèles (parallèles sur M bits), c'est à dire d'une manière homogène à ce qui a été indiqué par ailleurs pour le code de modulation.

Pour les raisons exposées plus haut, les transmissions à haut débit font appel désormais à des codes de modulation de type code de groupe MB/NB (par exemple 8B/10B) pour lesquels la propagation d'erreur est naturellement de M bits : l'inversion d'un bit de l'information codée peut entraîner après décodage celle de M bits de données.

Cette évolution n'a pas, jusqu'ici, entraîné de changement en ce qui concerne le code détecteur d'erreurs. Notamment le projet de norme FDDI (Fiber Distributed Data Interface) de l'ISO et l'article d'IBM déjà cité recommandent l'utilisation de codes cycliques binaires, tel que le code de FIRE, pour la détection des erreurs. Les codes cyclique binaires encore utilisés en association avec des codes de groupe pour la modulation, sont placés dans un environnement où ils sont moins efficaces : la sécurité des transmissions est donc moindre. De plus, avec une telle association de codes, il est difficile de rendre optimales les logiques de transcodage puisque le code de modulation doit être mise en oeuvre par une logique parallèle, alors que le code détecteur devrait l'être en logique série sur l'information non codée.

L'invention a donc aussi pour objet d'associer à la modulation par un code de groupe MB/NB, un code détecteur d'erreurs de la famille des codes de Reed et Solomon. Il s'agit encore de codes cycliques mais, à la différence des codes binaires opérant en série sur des bits d'information, les codes Reed-Solomon opèrent en parallèle sur des symboles de M bits (ou multiples de M bits). Leur domaine d'efficacité maximale est celui des paquets d'erreurs peu nombreux et confinés dans des symboles de M bits (ou multiples de M bits).

Dans le cas où les mots utilisateurs sont multiplexés avant codage et émission, le codage Reed-Solomon sera effectué directement à partir des mots utilisateurs, le multiplexage portant ensuite aussi bien sur les mots utilisateur que sur les mots de clé, de même longueur que les mots utilisateur.

Il est inutile de décrire en détail les procédés de codage et de détection d'erreurs du type Reed-Solomon dont la théorie et la mise en oeuvre sont bien connues en soi.

Nous allons maintenant décrire la mise en oeuvre du procédé de transmission selon l'invention.

La figure 1 représente des dispositifs d'émission et de réception pouvant être incorporés à un terminal d'un réseau d'ordinateurs. Cette figure a été précédemment décrite en ce qui concerne les éléments permettant une meilleure compréhension du procédé de transmission. On peut toutefois ajouter que les dispositifs d'émission et de réception communiquent avec le processeur du terminal par l'intermédiaire d'une unité d'interface et de gestion de protocole 11, qui peut être associée à des dispositifs de détection ou de correction d'erreurs. En particulier, il peut être prévu un générateur de clé 15 fonctionnant à l'émission et un détecteur d'erreurs 17 fonctionnant à la réception. Par ailleurs, le circuit de commande des dispositifs d'émission et de réception reçoit de l'interface 11 des signaux de commande CD, FL provenant du processeur du terminal. De même, le dispositif de réception envoie des signaux de contrôle C au processeur du terminal.

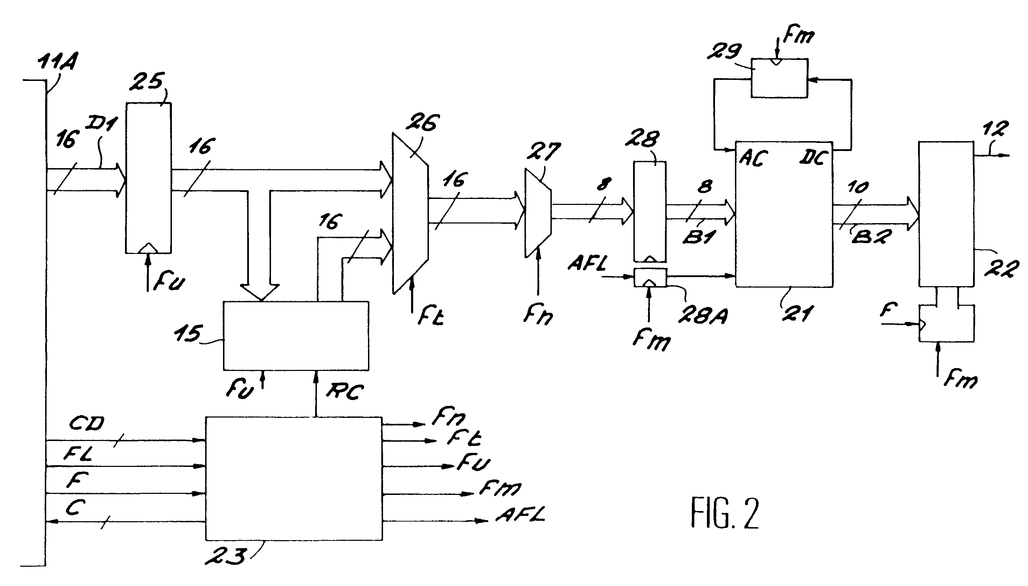

La figure 2 représente plus en détail un dispositif d'émission. L'interface d'émission 11A communique avec le dispositif d'émission par un bus de donnée D1 par l'intermédiaire duquel des mots utilisateur de 16 bits sont envoyés vers le dispositif d'émission. L'interface 11A émet également les signaux de commande CD, FL. Les signaux CD sont des signaux qui permettent l'initialisation et l'arrêt du dispositif d'émission. Les signaux FL sont indicatifs des indicateurs à émettre et sont générés par le dispositif de gestion de protocole de l'interface 11A. L'interface 11A comprend également une horloge locale fournissant des signaux d'horloge de fréquence f. Tous ces signaux sont transmis à un dispositif de commande d'émission 23 qui peut également fournir des signaux de contrôle C, tels que des signaux d'acquitement ou d'erreurs de fonctionnement du dispositif d'émis-

13

EP 0 269 481 B1

sion.

Les bits d'un même mot utilisateur sont transmis en parallèle par le bus D1 un registre d'entrée 25. La sortie du registre d'entrée 25 est reliée d'une part au dispositif de génération de clé 15 et d'autre part à l'entrée d'un multiplexeur 26, permettant de sélectionner soit des mots utilisateur, soit des mots de clé issus du générateur 15. La sortie du générateur de clé 15 est donc reliée à l'entrée du multiplexeur 26. Selon le mode de réalisation représenté, un mot utilisateur comporte plusieurs mots de donnée, aussi la sortie du multiplexeur 26 est reliée à l'entrée d'un second multiplexeur 27, dont les lignes de sortie sont reliées à l'entrée d'un registre 28. La sortie du registre 28 crée un bus B1 qui est relié à l'entrée du dispositif de codage 21 dont la sortie est reliée à un bus B2. Ainsi dans le cas d'un codage du type 8B/10B, le bus B1 comprendra huit lignes en parallèle et le bus B2 dix lignes en parallèle. Enfin, le bus B2 est relié à l'entrée parallèle d'un registre à décalage 22 qui constitue un circuit de conversion parallèle-série. Ce registre à décalage 22 possède une sortie série 12, une entrée d'horloge recevant le signal d'horloge f et une entrée de commande de chargement parallèle des données présentes sur le bus B2. Le circuit de codage 21 possède une sortie supplémentaire DC qui est reliée à l'entrée d'un dispositif de gestion de charge 29. La sortie du dispositif 29 est reliée à une entrée supplémentaire AC du dispositif de codage 21. Le rôle et la constitution du dipositif de gestion de charges 29 seront exposés ultérieurement.

Le générateur de clé 15 est du type Reed-Solomon. Ces générateurs sont bien connus dans la technique de détection et de correction d'erreurs, notamment dans l'application à des disques magnétiques.

Il est donc inutile de détailler davantage ce dispositif. Il convient toutefois de rappeler qu'un générateur de clé du type Reed-Solomon travaille selon le principe de la division d'un polynôme, dont les coefficients sont les mots du message à transmettre, par un polynôme spécifique du code Reed-Solomon. Pour cela, on utilise des registres décalage travaillant sur plusieurs bits en parallèle avec des rebouclages de façon à réaliser un automate de division par le polynôme du code. Dans le cas de l'exemple de la figure 2, les mots de donnée utilisateur comprennent 16 bits. Le polynôme du code Reed-Solomon pourra être de la forme $X^2 + X (T + I) + T$, où T est un élément d'un corps de Gallois F $(2^{16})$ et I l'élément neutre de ce corps. Avec un tel polynôme de degré 2, la clé générée par un message sera constituée par le reste de la division précitée par ce polynôme, sous la forme de deux mots de 16 bits présents dans deux registres du générateur de clé et ces deux mots de clé sont concaténés en fin de message.

Le dispositif de commande 23 génère des signaux de synchronisation ft, fu, fm, fn, servant à la synchronisation et à la commande des éléments tels que des registres et multiplexeurs faisant partie des dispositifs d'émission et de réception. Le dispositif de commande 23 génère également un signal de commande de génération d'indicateur AFL. Ce signal AFL est appliqué à l'entrée d'une bascule 28A dont la sortie est reliée à une entrée supplémentaire du dispositif de codage 21. Le dispositif de commande 23 fournit enfin des signaux RC de commande du générateur de clé 15.

Nous allons maintenant décrire le fonctionnement du dispositif d'émission de la figure 2. Il convient tout d'abord de rappeler qu'un message à émettre est constitué par plusieurs parties. Il comprend tout d'abord un délimiteur de début de trame qui est un indicateur particulier, le message proprement dit, et un délimiteur de fin de trame qui est un autre indicateur particulier. Entre les messages, l'émetteur génère des caractères de remplissage (en anglais fillers) destinés à entretenir le fonctionnement de l'extracteur d'horloge du récepteur.

Le message proprement dit est constitué par une succession de mots utilisateur de longueur fixe suivis éventuellement d'un certain nombre de mots de clé. Ainsi le dispositif de commande de l'émetteur devra avoir connaissance d'une part du fait que des indicateurs sont émis et d'autre part de la longueur du message ou du nombre total de mots utilisateur à transmettre. Ces informations sont fournies par les signaux de commande FL et CD. En fonction de ces signaux, le dispositif de commande 23 génère les signaux nécessaires au séquencement correct des circuits d'émission. En particulier le circuit de commande 23 génère un signal de commande fu à la fréquence des mots utilisateur. Ce signal fu sert à valider le registre d'entrée 25. Il sert également à synchroniser le dispositif de génération de clé 15. Le signal ft sert à commander le multiplexeur 26. Ce signal ft apparaît à la fin de la transmission d'un bloc complet de données utilisateur et autorise la transmission des mots de clé mémorisés dans le générateur de clé 15.

Dans l'exemple de réalisation de la figure 2, les mots de donnée à coder comprennent 8 bits alors que les mots de donnée utilisateur comprennent 16 bits. Ainsi un mot utilisateur est envoyé sous la forme de deux mots de 8 bits successifs grâce au multiplexeur 27. Ce multiplexeur 27 est commandé par un signal fn dérivé du signal fm ayant une fréquence appelée "fréquence mot" qui est égale à un multiple de la fréquence mot utilisateur fu. Un signal de même fréquence également désigné par fm est utilisé pour synchroniser le registre d'entrée 28 ainsi que la bascule 28A, le dispositif de gestion de charge 29 et le registre à décalage 22. On peut noter que les multiplexeurs 26 et 27 pourraient être remplacés par un multiplexeur unique comportant 32 lignes d'entrée et 8 lignes de sortie, et commandé en fonction de deux signaux ayant respectivement les fréquences ft et fn.

Après avoir défini les signaux de commande nous pouvons maintenant décrire le fonctionnement de l'émetteur lors de l'émission d'un message. Le dispositif de commande 23 reçoit d'abord un signal de commande d'émission en provenance de l'interface 11A, et le circuit de commande 23 déclenche, à partir du signal d'horloge f, la génération des signaux fm, fu, fn et ft. Le dispositif de commande reçoit un signal d'indicateur FL, et un signal AFL est appliqué à l'entrée de la bascule 28A. Le signal fu valide l'écriture du registre 25 ainsi que le générateur de clé 15 au rythme de la fréquence mot utilisateur. Le signal ft autorise le transfert des données contenues dans le registre d'entrée 25 vers le multiplexeur 27. Le signal fn permet de sélectionner alternativement les 8 premiers et les 8 derniers bits du mot utilisateur reçu. De même, un signal fm autorise l'écriture dans le registre 28. Il est bien évident que les signaux ft, fu, fm possèdent des fréquences dans des rapports déterminés mais les signaux désignés par la même référence présentent éventuellement des déphasages permettant de tenir compte des retards occasionnés par chaque étage du circuit. Par exemple le signal fm appliqué au registre 28 sera en avance de phase par rapport au signal fm appliqué à l'entrée de commande du registre décalage 22.

Lorsque le bloc de donnée à émettre a été codé et transmis, le circuit de commande 23 envoie le signal RC au dispositif de génération de clé 15 permettant la lecture des registres contenant les mots de clé. Simultanément le circuit de commande 23 positionne le signal ft de sorte que le multiplexeur 26 mette en communication la sortie du générateur de clé 15 avec l'entrée du multiplexeur 27. Les mots de clé sont ensuite codés comme des mots de donnée ordinaires.

Selon ce mode de réalisation, on peut noter que le registre à décalage 22 doit être capable de travailler à la fréquence la plus élevée. Si par exemple la fréquence f est fixée à 200 MHz, les circuits du dispositif d'émission commandés par fm ne travailleront qu'à la fréquence de 20 MHz. On pourrait donc réaliser le registre à décalage 22 en technologie ECL tandis que les autres éléments du circuit pourront être réalisés en technologie CMOS. Le débit utile de la transmission sera alors égal à 160 mégabits par seconde.

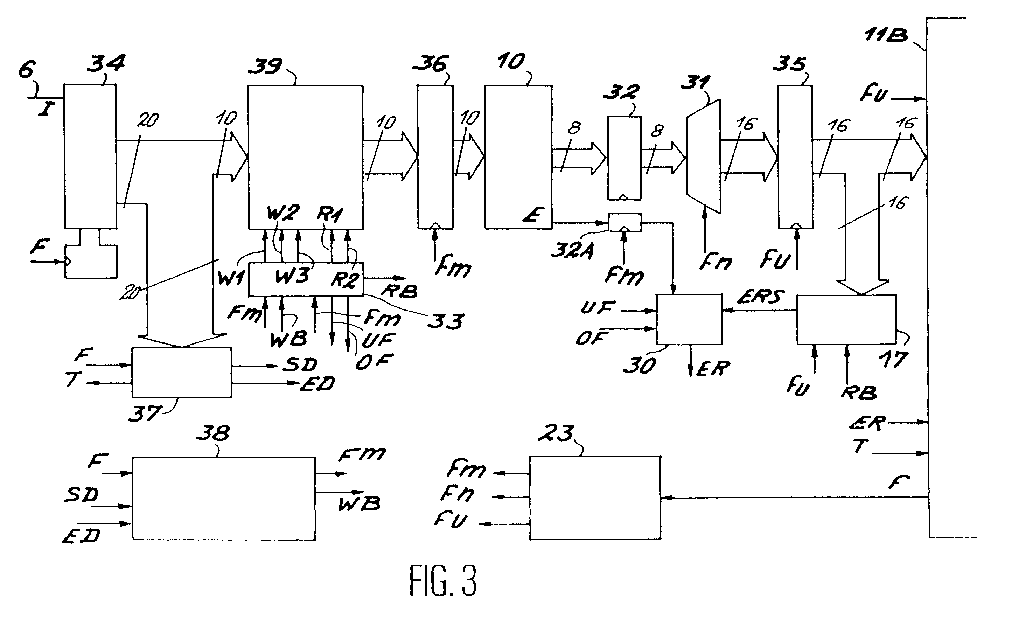

La figure 3 représente un dispositif de réception selon l'invention. Le message provenant d'un émetteur est transmis par l'intermédiaire d'un canal de transmission sous la forme de données binaires transmises en série. Après conversion, mise en forme et amplification, ces données apparaissent sur la ligne 6 ; elles sont synchrones de l'horloge F extraite du signal série reçu. La ligne 6 est reliée à l'entrée série I d'un registre à décalage 34, également synchronisé par l'horloge F, et qui constitue un convertisseur série-parallèle classique. La sortie parallèle du registre à décalage 34 est reliée à l'entrée du circuit de détection d'indicateurs 37. Ce circuit fournit à sa sortie les signaux représentant les différents indicateurs reconnus tels que le délimiteur de début de trame SD, le délimiteur de fin de trame ED, éventuellement un jeton T utilisé, par exemple, dans les réseaux en anneau.

Selon l'exemple représenté à la figure 3, le code concerné est un code 8B/10B associé à des indicateurs de 20 bits. Le registre à décalage 34 comprend donc au moins 20 étages car il doit fournir sur sa sortie parallèle autant de bits que peut en comporter un indicateur. Par contre, les mots de code ne comprennent que 10 bits et par conséquent, seuls les 10 premiers étages du registre à décalage seront utilisés pour transmettre les mots de code. Ainsi, les dix premiers étages du registre à décalage sont reliés à l'entrée d'un dispositif tampon 39 qui a pour rôle de faire passer de la synchonisation par l'horloge régénérée F à la synchronisation sur l'horloge locale f. Le dispositif tampon 39 est associé à un circuit de contrôle 33. La constitution et le fonctionnement des dispositifs 39 et 33 seront exposés plus en détail dans la suite de la description.

La sortie du dispositif tampon 39 est reliée à l'entrée d'un registre 36 synchronisé par un signal fm appelé horloge mot locale. La sortie du registre 36 est reliée à l'entrée du décodeur 10. Ainsi, selon l'exemple donné, le décodeur reçoit en entrée 10 bits en parallèle, et délivre en sortie 8 bits en parallèle correspondant à un mot de donnée décodé. Le décodeur 10 comporte également une sortie supplémentaire E affectée à un signal d'erreur. Les mots de donnée décodés issus du décodeur 10 sont reçus à l'entrée d'un registre 32. De même le signal d'erreur est reçu à l'entrée d'une bascule 32A. Le registre 32 et la bascule 32A sont également synchronisés par le signal fm. La sortie du registre 32 est reliée à l'entrée d'un démultiplexeur 31 qui permet de transformer les mots de 8 bits sortant du décodeur 10 en des mots de 16 bits. Un tel démultiplexeur 8/16 est donné exclusivement à titre d'exemple dans le cas particulier où les mots de donnée et les mots utilisateur sont respectivement des mots de 8 bits et 16 bits. Il est bien évident que la réalisation du démultiplexage pourrait être facilement généralisée dans tous les cas où les mots utilisateur comprendraient un nombre de bits égal à un multiple du nombre de bits des mots de donnée.

La sortie du démultiplexeur 31 est reliée ensuite à un autre registre 35 constitué par 16 bascules. La sortie de ce registre est reliée d'une part à l'interface d'entrée 11B du terminal et d'autre part à un circuit de détection d'erreur 17.

Le dispositif de réception de la figure 3 comprend également le circuit de commande 38 et le circuit de commande 23 déjà cité en référence à la figure 2. Le circuit 38 reçoit le signal d'horloge régénéré F, des signaux indiquant la présence de délimiteurs de début ou de fin de trame SD et ED. En fonction de ces signaux d'entrée,

EP 0 269 481 B1

le circuit 38 fournit d'abord des signaux de synchronisation Fm correspondant à la fréquence mot reçue. Ce circuit délivre également un signal de commande d'écriture WB du dispositif tampon 39.Les signaux Fm et WB servent de signaux d'entrée au circuit de commande 33 du dispositif tampon 39. Rappelons que le circuit 23 reçoit le signal d'horloge locale f et fournit des signaux de commande fn du démultiplexeur 31 et des signaux d'horloge mot locale fm obtenus à partir de l'horloge locale f. Les signaux fm commandent le registre 36, le registre 32 et la bascule 32A. Il est évident que les signaux appliqués respectivement au registre 36, au registre 32 et au démultiplexeur 31 devront être déphasés de façon adéquate pour tenir compte des retards provoqués au passage des différents éléments du circuit. Le circuit 23 fournit enfin un signal d'horloge mot utilisateur fu qui est appliqué à l'entrée d'horloge du registre 35 et sert également de signal de synchronisation du circuit de détection d'erreurs 17.

Le circuit de détection d'erreurs 17 est selon une caractéristique intéressante de l'invention un détecteur d'erreurs du type Reed-Solomon. De façon connue en soi, les détecteurs d'erreurs du type Reed-Solomon sont constitués dans l'exemple présent, par deux registres à 16 bits, avec des rebouchages constituant un dispositif à décalage à deux étages permettant de réaliser un diviseur par le polynôme du code Reed-Solomon.

Pour réaliser le détecteur d'erreur, les 16 sorties de chaque registre sont reliées à l'entrée d'une porte OU associée au registre correspondant. Les sorties des portes OU indiquent, en fin de message, l'existence d'erreurs éventuelles. Si ce détecteur reconnaît une erreur dans le message transmis, il délivre un signal ERS à l'entrée du circuit 30 qui regroupe toutes les erreurs détectées au niveau du dispositif de réception. En particulier, il reçoit le signal E provenant du décodeur 10. Il recoit également les signaux OF et UF provenant du circuit de commande 33 du dispositif tampon 39. Ces deux signaux OF et UF sont indicatifs d'un dépassement de capacité du dispositif tampon. Les signaux d'erreurs ERS, E, OF, UF sont regroupés dans le circuit 30 qui délivre un signal global d'erreur ER à l'interface 11B.

Pour décrire le fonctionnement du dispositif de réception, il convient de rappeler que les signaux reçus forment une trame composée successivement d'un délimiteur de début de trame SD, de mots de donnée, de mots de clé et d'un délimiteur de fin de trame ED. Selon l'exemple décrit, les délimiteurs SD et ED comprennent 20 bits. Avant décodage, la clé de détection d'erreur est formée de deux mots de 20 bits.

Les signaux provenant du canal de transmission permettent le calage en fréquence et en phase du signal d'horloge reçu F. Ce signal F commande le fonctionnement du registre à décalage 34 qui mémorise 20 données binaires reçues, ces données se décalant d'un étage à chaque impulsion d'horloge F.

Dès que le délimiteur de début de trame est présent dans le registre 34, le détecteur d'indicateurs 37 le reconnaît et délivre le signal SD au circuit de commande 38. Le circuit de commande 38 délivre de façon permanente un signal d'horloge mot reçue Fm ayant une fréquence égale à un dixième de la fréquence F. En réponse au signal SD, et après un retard Tm correspondant à 10 périodes de l'horloge F, le circuit 38 fournit le signal WB. Ce signal WB active le circuit de contrôle 33 dont le fonctionnement détaillé sera décrit plus loin. Le circuit 33 fournit alors les commandes d'écriture W1, W2, W3 du tampon 39. Le signal fm est un signal permanent d'horloge mot locale ayant une fréquence égale à un dixième de la fréquence de l'horloge locale f. Ce signal fm est reçu par le circuit de contrôle 33 qui fournit les signaux de lecture R1, R2 du tampon 39, et le signal RB indiquant que des mots d'une trame reçue sont présents à la sortie du tampon 39. Le mode de fonctionnement de ces circuits sera décrit plus loin. L'horloge mot locale fm commande également les registres 36, 32 et la bascule 32A de sorte que les mots de code sont décodés par le décodeur 10 en synchronisme avec les signaux d'horloge mot locale fm.

Comme pour l'émetteur décrit précédemment, le signal fn qui commande le démultiplexeur 31 commute entre les valeurs 0 et 1 à chaque impulsion de l'horloge fm. Ainsi le registre 35 sera chargé par des mots de 16 bits formés à partir de deux mots de donnée de 8 bits. Le registre 35 est commandé par le signal d'horloge mot utilisateur fu ayant une fréquence moitié de la fréquence fm.

Ainsi, les mots utilisateur issus du démultiplexeur 31 et du registre 35 sont traités par le détecteur d'erreur 17 synchronisé par le signal fu. Le détecteur d'erreur 17 reçoit du circuit de contrôle 33 le signal RB, qui indiquera la fin de la trame reçue.

Lorsque le détecteur d'indicateur 37 reconnaît la présence du délimiteur de fin de trame, il délivre le signal ED au circuit 38.

Un temps Tm après la réception de ce signal, le circuit 38 met à zéro le signal WB. Un temps voisin de 1,5 Tm après cet événement, le circuit 33 met à zéro le signal RB.

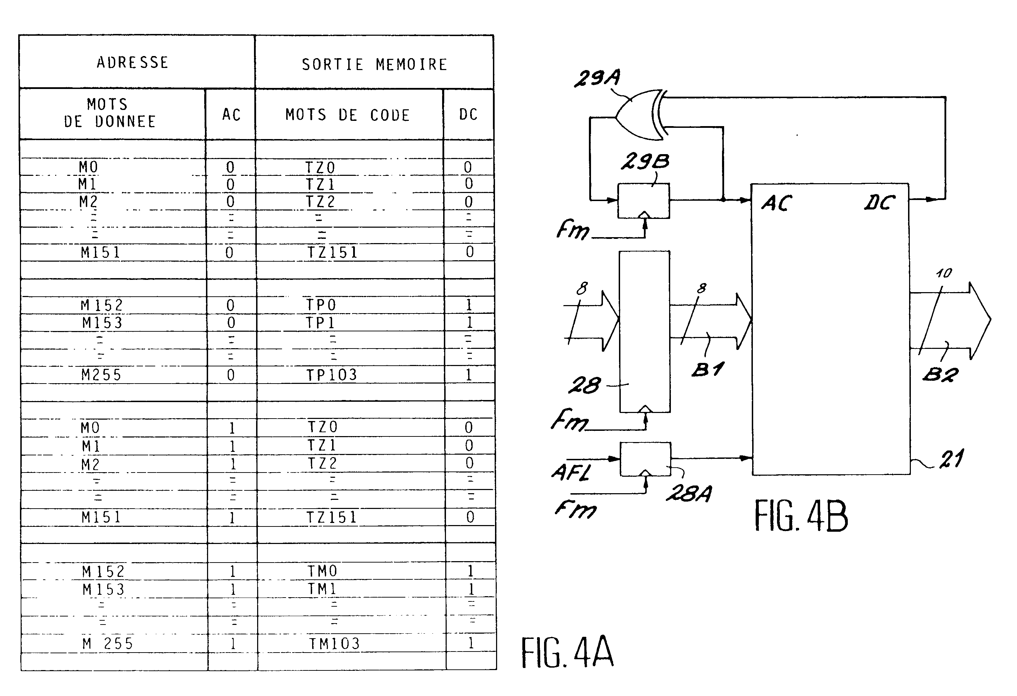

Les figures 4A et 4B vont permettre de mieux expliquer la constitution et le fonctionnement du dispositif de codage 21 représenté à la figure 2.

Le dispositif de codage 21, le registre 28, la bascule 28A déjà évoqués en référence à la figure 2 se retrouvent sur la figure 4B. Selon un mode de réalisation particulier, le dispositif de codage est constitué simplement par une mémoire telle qu'une mémoire morte ou une mémoire programmable délivrant en sortie des mots de 11 bits adressés par des mots de 10 bits. Parmi les 10 lignes d'adresse de la mémoire 21, 8 forment le bus B1 utilisé pour recevoir les mots de données à coder. Une ligne d'adresse supplémentaire est reliée à la sortie de la bascule 28A déjà décrite précédemment et une dixième ligne d'adresse AC reçoit le signal de sortie du dispositif de gestion de charges 29. Ce dispositif de gestion de charges est constitué simplement par une porte OU EXCLUSIF 29A dont la sortie est reliée à l'entrée d'une bascule 29B, la sortie de cette bascule étant reliée à la ligne d'adresse AC de la mémoire 21. La porte OU EXCLUSIF 29A sa première entrée reliée à la sortie DC de la mémoire 21 et sa seconde entrée est reliée à la sortie de la bascule 29B. La bascule 29B est synchronisée par le signal d'horloge mot fm.

Une telle disposition de la mémoire 21 permet à celle-ci de générer à la fois les indicateurs et les mots de code.

En effet en fonction du signal AFL reçu et des mots d'entrée présents sur le bus B1, la mémoire 21 fournira en sortie sur le bus B2 un mot de 10 bits correspondant à un demi-indicateur. Au signal d'horloge mot suivant la mémoire fournira les 10 autres bits formant la fin de l'indicateur. Lorsque l'entrée d'adresse AFL n'est plus validée, la mémoire fournit en sortie des mots de code lus à l'emplacement correspondant aux au 8 bits d'adresse provenant du registre 28. Ainsi la mémoire 21 fera correspondre à chaque mot de donnée du registre 28 un mot de code associé.

Afin d'expliquer le fonctionnement du dispositif de gestion de charges, il convient de décrire la configuration interne des données contenues dans la mémoire 21. La figure 4A illustre un cas particulier d'un code 8B/10B selon lequel il existe 152 mots de donnée que l'on peut associer à 152 mots de code de charge nulle. Ces mots de donnée sont indiqués par M0, M1...M151 et chacun de ces mots de donnée est associé à un mot de code correspondant TZ0, TZ1...TZ151. Les autres mots de donnée M152...M255 sont ceux qui correspondent à des mots de code de charge non nulle respectivement TP0, TP1...TP103 ou TM0, TM1...TM103. En fonction de la valeur AC mémorisée dans la bascule 29B, les mots de données associés à des mots de code de charge non nulle adresseront des mots de code de charge positive TP0...TP103 ou des mots de code de charge négative TM0...TM103. De plus, selon que le mot de code adressé est un mot de code de charge nulle ou non, le bit supplémentaire DC prendra la valeur "0" ou "1" logique respectivement. Après ces explications concernant la configuration des données dans la mémoire 21, le fonctionnement du circuit de gestion de charges 29A, 29B devient évident. Si l'on part d'un état où la valeur logique mémorisée dans la bascule 29B est égale à 0, si l'on suppose que le premier mot de donnée à coder correspond à un mot de code de charge nulle, alors la nouvelle valeur de AC est 0. Tant que les mots de code suivants auront une charge nulle, la valeur AC restera égale à 0. Dès qu'un mot de donnée correspondra à un mot de code de charge non nulle, comme AC a été supposé égal à 0, le mot de code correspondant à ce mot de donnée aura une charge positive. Simultanément la sortie de la porte 29A prendra la valeur 1. Ainsi la bascule 29B sera chargée avec la valeur logique 1. Ensuite si un nouveau mot de donnée correspond à un mot de code de charge nulle la valeur AC reste inchangée et donc garde la valeur 1. AC conserve cette valeur aussi longtemps que des mots de données correspondants à des mots de code de charge nulle apparaissent en entrée. Dès qu'apparaît un mot de données correspondant à un mot de code de charge non nulle, AC ayant la valeur 1, le nouveau mot de code correspondant à ce mot de donnée aura une charge opposée à la charge du précédent mot de code de charge non nulle. Comme AC et DC avaient la valeur 1, la bascule sera chargée avec une nouvelle valeur de AC égale à 0. On peut vérifier aisément que le même mécanisme est obtenu si l'on part d'une valeur de AC égal 1. Ainsi on est sûr que, quelles que soient les conditions initiales, un mot de donnée associé à un mot de charge non nulle sera toujours codé par celui des deux mots de code associé à ce mot de donnée qui a une charge opposée à la charge du précédent mot de code de charge non nulle qui était apparu précédemment.

Il est évident que l'on pourrait envisager un autre mode de réalisation où à la place d'une mémoire on utiliserait des circuits logiques cablés réalisant la même fonction. Cependant dans ce cas un circuit de codage cablé serait spécifique d'un code déterminé. Par contre l'utilisation d'une mémoire permet d'utiliser exactement les mêmes circuits pour tous les codes répondant aux critères choisis. Dans ce cas, seul le contenu de la mémoire doit être modifié si l'on veut choisir un autre code.

Le circuit de décodage 10 représenté à la figure 3 peut également être réalisé à l'aide d'une mémoire. Cette mémoire est adressée par les 10 bits du mot de code reçu et fournit en sortie des mots de donnée de 8 bits. Compte tenu du procédé de codage tel que décrit précédemment, il conviendra évidemment que les deux mots de code chargés associés au même mot de donnée adressent la mémoire à des emplacements contenant exactement la même valeur représentant un unique mot de donnée.

Selon ce mode de réalisation utilisant une mémoire, il apparaît que la mémoire de décodage devra contenir 1024 mots de 8 bits pour décoder seulement 256 mots de données. Il en résulte que certaines valeurs de l'adresse appliquée à la mémoire 10 ne correspondent à aucun mot de donnée prévu dans le code. Selon, une caractéristique de l'invention, cet inconvénient apparent a été utilisé d'une façon originale mais au prix d'un bit supplémentaire E par mot de donnée dans la mémoire.

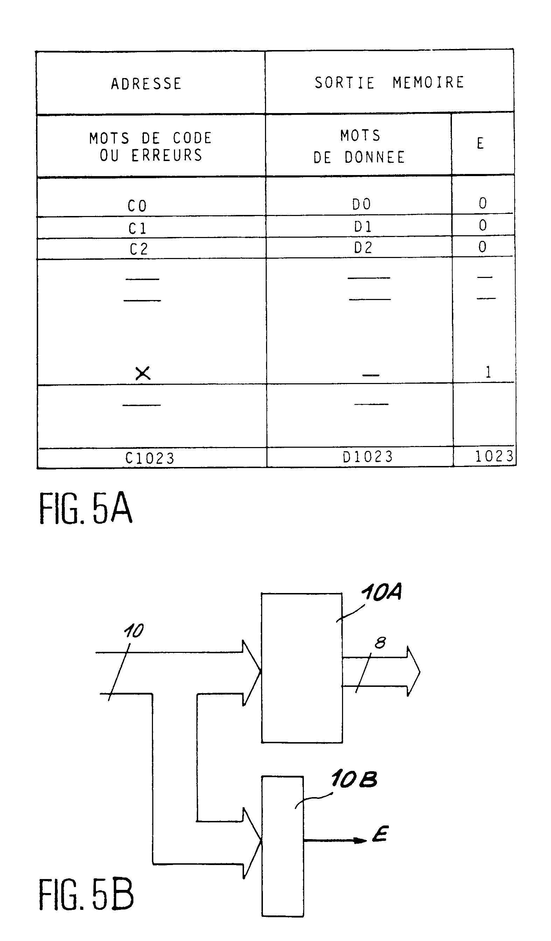

Pour illuster cela, la figure 5A représente la correspondance entre les adresses Co,...,C1023 de la mémoire 10 et les données Do,...,D1023 associées à ces adresses. Une adresse quelconque appliquée à la mémoire peut être un mot de code ou non. Dans ce dernier cas, une erreur s'est produite et il est intéressant de pouvoir la détecter. Par exemple, si l'on suppose que C0, C1, C2 sont des mots de code correspondant respectivement aux données D0, D1, D2, le bit supplémentaire E associé au mot de donnée sera égal à 0, indiquant par là que l'adresse appliquée correspond à un mot de code. Par contre si, par suite d'une erreur de transmission, les 10 bits d'adresse reçus ne correspondent à aucun mot de code, le bit supplémentaire E prendra la valeur 1. Ainsi la ligne de sortie E de la mémoire 10 prend une valeur logique fonction de l'apparition d'un mot qui n'appartient pas au code. Ce signal d'erreur sera transmis par l'intermédiaire du circuit 30 à l'interface de réception 11B.

Une variante de réalisation du dispositif de décodage 10 est représentée à la figure 5B. Comme pour le circuit de codage, il n'est pas indispensable d'utiliser une mémoire comme dispositif de décodage. Le décodeur peut être également réalisé au moyen d'un circuit logique cablé 10A. Cependant, même dans ce cas, il est possible d'obtenir une indication d'un mot de code erroné comme dans le cas de la réalisation avec une mémoire. Pour cela, il suffit de connecter sur les lignes d'entrée du circuit de décodage 10A les lignes d'adresse d'une mémoire auxiliaire 10B. Cette mémoire auxiliaire aura donc autant de lignes d'adresse que de lignes d'entrée et à chaque adresse sera associé un mot binaire E. Par exemple, dans le cas où les mots de code comprennent 10 bits, la mémoire 10B aura une capacité de 1024 bits. De même que dans le mode de réalisation précédent, lorsqu'une adresse est appliquée à la mémoire et ne correspond à aucun mot de code, la mémoire fournira en sortie la valeur logique 1. Si par contre l'adresse correspond à un mot de code, la sortie de la mémoire aura la valeur logique 0.

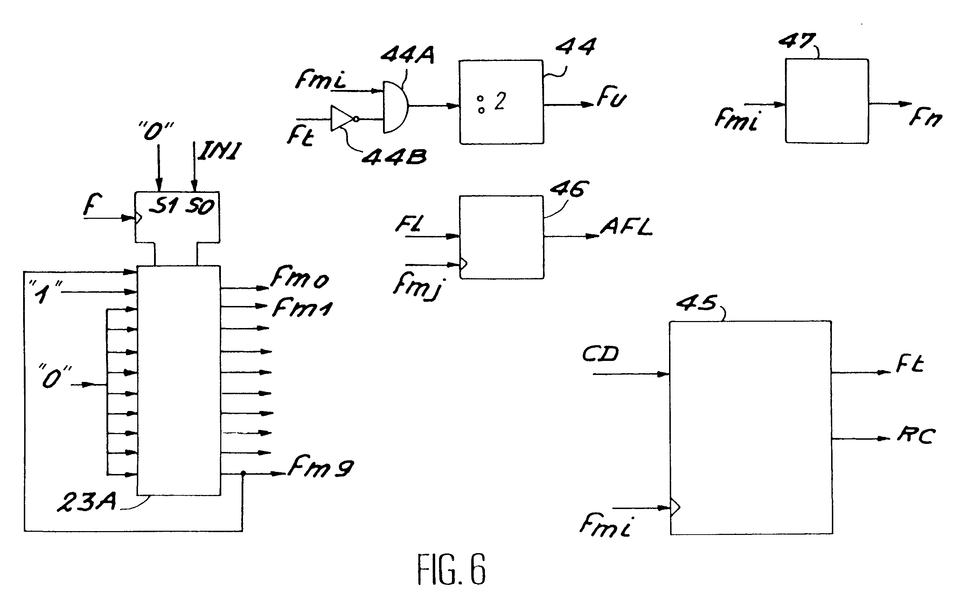

La figure 6 représente plus en détail certains circuits du dispositif de commande 23 du dispositif d'émission. Un générateur d'horloge mot locale est constitué essentiellement par un registre à décalage 23A. Ce registre comprend 10 étages dont les entrées parallèles sont positionnées à la valeur "1" logique pour la première entrée et la valeur "0" logique pour les 9 autres entrées. Ce registre comporte 10 lignes de sortie fm0, fm1...fm9. La dernière sortie fm9 est rebouclée sur l'entrée série du registre à décalage. Le registre reçoit également le signal d'horloge locale f sur son entrée d'horloge. Le registre comporte également deux entrées de commande S0, S1 dont les valeurs conditionnent le fonctionnement du registre. L'entrée S1 correspond à une commande de maintien de l'état du registre. Comme la fonction "maintien" du registre n'est pas utilisée, l'entrée S1 est constamment forcée à la valeur "0" logique. Lorsque S0 reçoit la valeur "0" logique, le registre est commandé en chargement parallèle. Si S0 prend la valeur "1" logique, le registre est commandé en décalage. L'horloge mot locale fm étant permanente, la commande S1 n'a la valeur "0" logique que pendant la période de chargement initial déterminée par le signal INI. De tels registres à décalage pouvasnt être commandés en mode chargement parallèle, en mode maintien ou en mode décalage sont bien connus dans la technique et il est inutile de détailler davantage leur réalisation. Le rebouclage de la dernière sortie fm9 sur l'entrée série du registre a pour effet de produire sur les différentes sorties fm0...fm9 des signaux ayant une fréquence égale à un dixième de la fréquence f, ces signaux étant déphasés les uns par rapport aux autres d'une valeur égale à un multiple entier de la période du signal d'horloge locale f. Les signaux fm0...fm9 constituent ce qui a été appelé précédemment l'horloge mot locale. Le circuit de commande 23 comprend également un diviseur de fréquence par deux 44 recevant en entrée le signal de sortie d'une porte ET 44A. La première entrée de la porte ET reçoit un des signaux d'horloge mot fmi. Son autre entrée reçoit le signal de sortie d'un inverseur 44B dont l'entrée reçoit le signal ft. Le signal fu commande le registre 25 et le générateur de clé 15.

Un circuit 46 générant le signal de commande d'indicateur AFL appliqué à la bascule 28A associée au codeur 21 reçoit de l'interface 11A un signal FL indiquant que les mots à coder sont des indicateurs. Le circuit 46 reçoit également un signal d'horloge mot fmj. A la réception du signal FL, le circuit 46 positionne le signal AFL à la valeur "1" logique pendant la durée d'émission de deux mots de donnée.

Le circuit 47, ayant la fonction d'une bascule T (Toggle) fournit le signal fn de commande du multiplexeur 27 en réponse au signal fmi issu d'une des sorties du registre à décalage 23A.

Un ensemble de circuits 45, génère les signaux ft et RC en fonction du signal fmi et du signal CD, issu de l'interface d'émission 11A, indicatif de la longueur de la trame du message à émettre.

Le signal ft prend la valeur "1" logique lorsque le dernier mot de donnée a été transmis et conserve cette valeur pendant une durée correspondant à la transmission de deux mots supplémentaires. Ainsi, pendant cette durée, le multiplexeur 26 est positionné pour mettre en communication le générateur de clé 15 avec l'entrée du second multiplexeur 27 et d'autre part le signal fu est inhibé, ce qui arrête le fonctionnement en décalage du générateur de clé 15.

Le signal RC prend la valeur "1" logique à la fin de la transmission du premier mot de clé et conserve cette valeur pendant la durée nécessaire à la transmission du second mot de clé. Lorsque RC = 0, le premier registre du générateur de clé est validé tandis que lorsque RC = 1, le second registre est validé.

La réalisation pratique des circuits 45 ne pose pas de difficultés particulières et il est inutile de fournir plus de détails à ce sujet.

Le fonctionnement des circuits représentés à la figure 6 est le suivant. En début d'émission l'interface 11A positionne le signal CD, Le registre 23A fonctionne en décalage et fournit les signaux fm0...fm9 d'horloge mot. L'interface d'émission positionne également le signal FL qui provoque la mise à 1 du signal AFL. Le diviseur de fréquence par deux 44 fournit le signal d'horloge mot utilisateur fu. Le signal fu valide le registre d'entrée 25 et déclenche le fonctionnement du générateur de clé 15. La sortie fn du circuit 47 commute entre 0 et 1 à chaque signal d'horloge mot fmi reçu. Ainsi, le registre d'entrée 25, le circuit générateur de clé 15, le multiplexeur 26, le multiplexeur 27 et le registre d'entrée 28 du codeur 21 sont synchronisés par les différents signaux générés. Initialement, AFL ayant la valeur "1" logique, les deux premiers mots de code générés par le codeur 21 seront en fait des moitiés d'indicateurs identifiés en fonction des mots présents à l'entrée. Ensuite, le circuit 46 positionne automatiquement le signal AFL à la valeur "0" et les mots de données suivants seront codés normalement par le codeur 21. Lorsque le circuit 45 délivre ft = 1, indiquant la fin du bloc de donnée à émettre, le générateur de clé 15 est arrêté. De même le signal ft met en communication, par l'intermédiaire du multiplexeur 27, la sortie du générateur de clé 15 avec le registre d'entrée 28 du codeur 21. Le signal ft reste à la valeur "1" logique pendant le temps nécessaire à l'émission, commandée par le signal RC, de deux mots de clé. Ensuite, Ft repasse à 0 et l'interface d'émission 11A positionne à nouveau le signal FL qui permettra l'émission d'un nouvel indicateur qui sera le délimiteur de fin de trame ED.

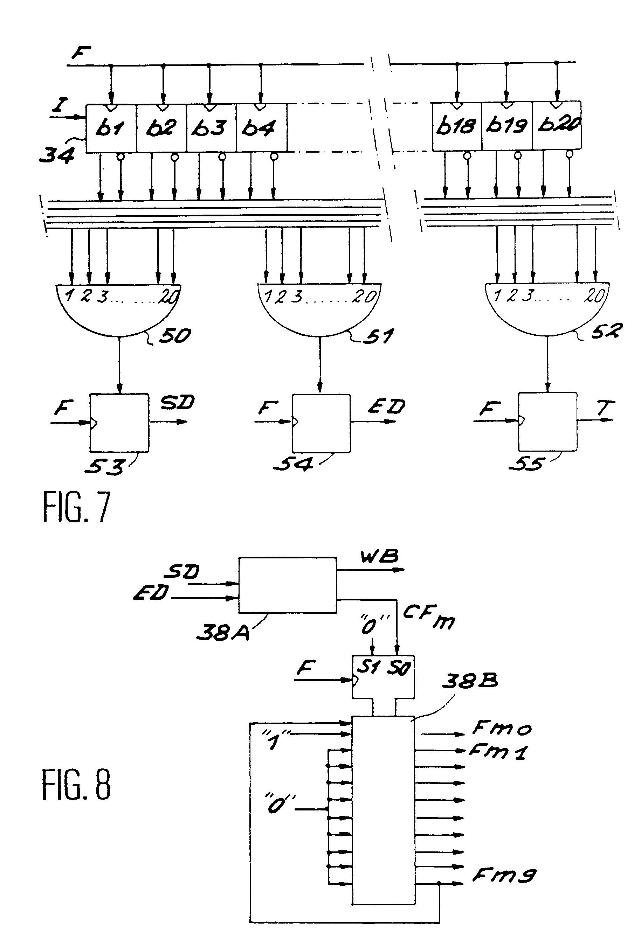

La figure 7 représente plus en détail le registre décalage 34 et le dispositif de détection d'indicateur 37 qui ont déjà été mentionnés en référence à la figure 3. De façon classique le registre à décalage 34 est constitué par une pluralité de bascules b1, b2,...,b20 montées en décalage, le premier étage b1 recevant les signaux binaires I provenant de la ligne 6. Chacune des bascules reçoit sur son entrée d'horloge le signal d'horloge F issu du régénérateur d'horloge. Comme l'exemple de réalisation concerne un code 8B/10B associé à des indicateurs comprenant 20 bits, il convient que le registre décalage 34 comporte au moins 20 bascules. De façon classique chacune des bascules présente une sortie directe et une sortie inverseuse, cette dernière étant symbolisée par un petit rond.

Le détecteur d'indicateur 37 est constitué essentiellement par des portes ET ayant autant d'entrées que un indicateur peut avoir de bits. Les portes ET auront donc 20 entrées pour l'exemple représenté.

Pour réaliser un détecteur quelconque il suffira d'utiliser autant de portes ET que d'indicateurs nécessaires pour le procédé de transmission. Le dispositif de la figure 7 concerne le cas où seulement trois indicateurs SD, ED et T sont utilisés, et où les indicateurs n'ont pas de segments communs.

La connexion entre le registre à décalage 34 et le détecteur est réalisée de la façon suivante. Une des deux sorties de chaque bascule, la sortie directe ou la sortie inverseuse, est reliée à une entrée de chacune des portes ET 50, 51, 52. On choisira évidemment celle des sorties de chacune des bascules en fonction de l'indicateur que l'on veut décoder. Ainsi le contenu des 20 bascules du registre 34 est en permanence contrôlé par les portes ET 50, 51, 52 et lorsque le registre contient un ensemble de bits correspondant à un des indicateurs, la sortie de la porte ET correspondante prend la valeur "1" logique. Chacune des sorties des portes ET est reliée à une des bascules 53, 54, 55. Les sorties directes des dix premières bascules du registre 34 sont également reliées à l'entrée du dispositif tampon 39. Ces connexions servent à établir la liaison entre les données du message constituées par des mots de 10 bits et la partie aval du dispositif de décodage.

La figure 8 représente une partie du dispositif de commande de réception 38 qui sert essentiellement à générer un signal d'horloge mot reçue. Ce circuit comprend un registre à décalage 38B recevant sur son entrée d'horloge le signal d'horloge régénéré F. Le registre à décalage 38B possède deux entrées de commande S0, S1 qui en fonction des signaux qui leur sont appliqués déterminent le fonctionnement du registre décalage. Lorsque S1 égale 1, le registre est en position de maintien quelle que soit la valeur appliquée à son entrée S0. Lorsque S0 et S1 sont à "0" logique, le registre est en position de chargement parallèle. Lorsque S0 prend la valeur logique 1 et S1 reste à 0, le registre fonctionne en décalage, synchronisé par le signal F. Le registre à décalage est commandé par le circuit logique 38A, dont la sortie CFm est reliée à l'entrée S0 du registre à décalage. Le circuit logique 38A est réalisé de sorte que le signal CFm, qui a généralement la valeur "1" logique, prenne la valeur "0" logique pendant une période de l'horloge F lorsqu'un délimiteur de début de trame SD a été détecté. La première entrée parallèle du registre à décalage est forcée en permanence à la valeur "1" logique, tandis que ses 9 autres entrées sont forcées à la valeur "0" logique. La dixième sortie Fm9 du registre à décalage est rebouclée sur son entrée série.

Lorsqu'un délimiteur de début de trame SD est détecté, le signal CFm prenant brièvement la valeur "0" logique, le registre 38B passe en mode chargement parallèle, ce qui a pour effet de synchroniser l'horloge mot reçue Fm sur le début de trame. Puis, aussi longtemps que le signal SD a la valeur "0" logique, c'est à dire tant qu'un nouveau délimiteur SD n'a pas été détecté, les entrées de commande S0 et S1 du registre 38B ayant la valeur "1" logique, ce registre fonctionne en mode décalage sur chacune des dix sorties apparaîtront des signaux appelés "horloge mot reçue", Fm0, Fm1,...,Fm9, ayant une fréquence égale à un dixième de la fréquence F, chacun de ces signaux étant déphasé par rapport à l'un des autres d'une valeur égale à un multiple de la période de l'horloge régénérée F. Nous verrons dans la suite de la description comment sont utilisés les signaux d'horloge mot reçue.

Le circuit 38A génère d'autre part un signal WB qui prend la valeur "1" logique un temps Tm après la réception d'un délimiteur SD, et la valeur "0" logique Tm après la réception d'un délimiteur ED. Le signal WB indique la présence de mots de la trame reçue à l'entrée du tampon 39, et commande l'accès en écriture à ce tampon.

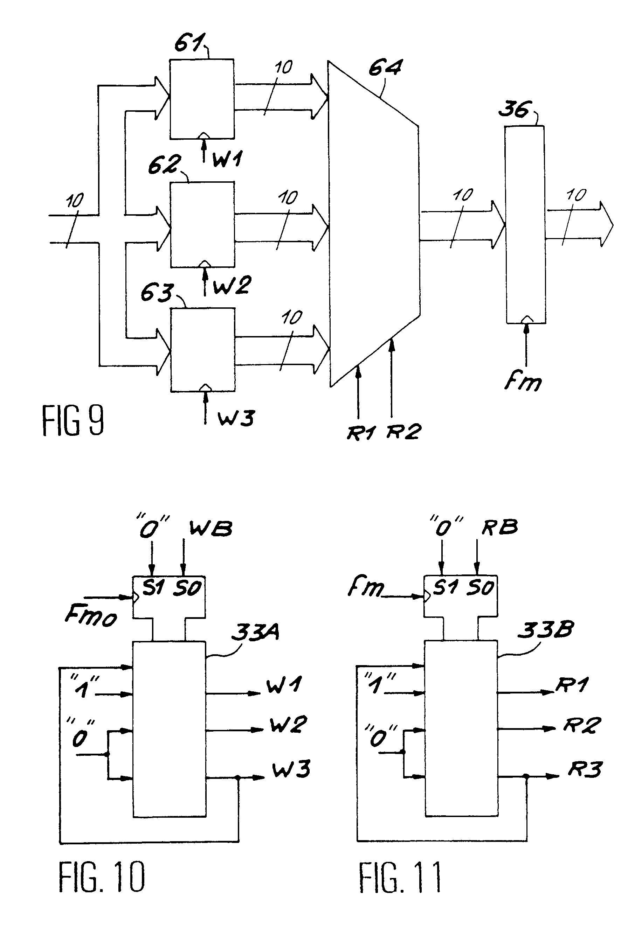

La figure 9 représente un mode de réalisation du dispositif tampon 39 représenté à la figure 3. Ce dispositif comprend 3 registres à 10 bits 61, 62, 63, chacun de ces registres comprenant 10 lignes d'entrée reliées aux dix premières bascules du registre à décalage 34. Les écritures dans les registres 61, 62, 63 sont commandées par des signaux d'horloge W1, W2, W3 respectivement. Chacun des registres comprend 10 lignes de sortie qui sont reliées à l'entrée d'un multiplexeur 64 ayant 10 lignes de sortie. Le multiplexeur 64 est commandé par deux signaux de sélection R1, R2. La sortie du multiplexeur 64 est reliée à l'entrée du registre 36. Lorsque R1 égale 1 et R2 égale 0 la sortie du registre 61 est mise en communication avec le registre 36, lorsque R1 égale 0 et R2 égale 1 le registre 62 est mis en communication avec le registre 36 et lorsque R1 et R2 sont égaux à 0 le registre 63 est mis en communication avec le registre 36.

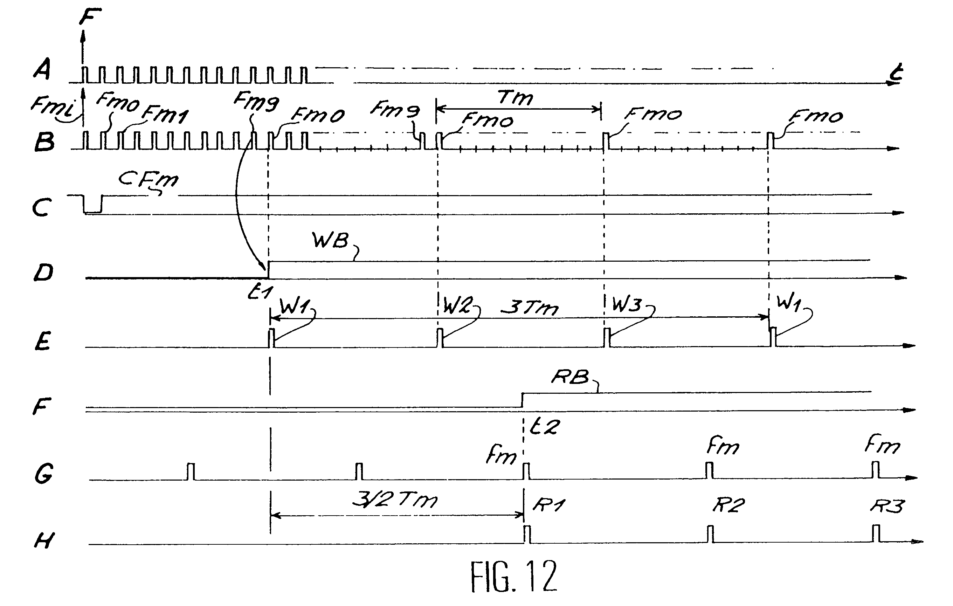

Les signaux W1, W2, W3 sont générés par le circuit représenté à la figure 10. Les signaux R1, R2 sont générés par le circuit représenté à la figure 11. La figure 12 représente des chronogrammes permettant d'expliquer le fonctionnement du dispositif tampon et des circuits représentés aux figures 10 et 11. Pour décrire le fonctionnement du dispositif tampon 39, plaçons-nous dans une station R au moment où celle-ci reçoit un message issu d'une station E. Le dispositif tampon 39 de R reçoit en entrée des mots de 10 bits d'information codée, à un rythme défini par l'horloge mot reçue Fm extraite du signal venant du canal. Le rôle du dispositif tampon est de transférer ces mots vers sa sortie, où ils sont lus à un rythme défini par l'horloge mot locale fm de la station R. Fm est déterminée par l'horloge locale de la station émettrice E ; les horloges locales ayant même fréquence nominale, l'écart de fréquence entre Fm et fm dans la station R est très faible mais non nul, et la relation de phase entre ces deux signaux est quelconque et variable. Le dispositif tampon 39 doit être tel que, compte tenu de la tolérance sur la fréquence des horloges locales f, et de la longueur maximale des trames, la station R reçoive dans son registre 36 tous les mots de la trame émise par E, chacun une seule fois ; et il faut que le dispositif tampon 39, s'il approche d'une situation où cette règle ne serait plus respectée, affirme un signal d'alarme (UF ou OF). Ceci exige que les trames émises par la station E soient séparées par des caractères de remplissage (en anglais : fillers) et que ces caractères ne traversent pas le dispositif tampon. Pendant la réception des caractères de remplissage le dispositif tampon se place au repos en situation nominale. Il fonctionne pendant les intervalles de temps où le signal WB a la valeur "1" logique.

La profondeur P du tampon est le nombre de ses registres : ici 3 ; elle a pour effet de multiplier par P l'intervalle de temps pendant lequel les mots reçus peuvent être exploités dans les circuits rythmés par l'horloge locale fm.

Le circuit représenté à la figure 10 fait partie du circuit de commande 33 du dispositif tampon 39. Ce circuit est constitué essentiellement par un registre à décalage 33A recevant sur son entrée d'horloge un signal d'horloge mot reçue Fm0, et sur son entrée de commande S0 un signal WB qui commande le registre en fonction décalage lorsqu'il prend la valeur "1" logique. L'entrée de commande S1 du registre 33A est forcée à la valeur "0" logique. Lorsque SO est aussi à la valeur "D" logique le registre est en position de chargement parallèle. Le registre à décalage 33A comprend trois étages et possède trois lignes d'entrée parallèle. La première ligne d'entrée est forcée en permanence à la valeur "1" logique et les deux autres entrées parallèles sont forcées à la valeur "0" logique. Le registre a trois lignes de sortie W1, W2, W3 reliées respectivement aux entrées d'horloge des registres 61, 62, 63 du dispositif tampon. La sortie W3 du registre est rebouclée sur son entrée série.

Les chronogrammes A, B, C, D et E représentés à la figure 12 vont permettre de mieux comprendre le fonctionnement.

Le chronogramme A représente le signal d'horloge régénéré F.

Le chronogramme B représente les signaux d'horloge mot reçue Fm0, Fm1...Fm9 délivrés par le registre 38B de la figure 8.

Le chronogramme C représente le signal CFm appliqué au registre 38B de la figure 8.

Le chronogramme D représente le signal WB de sortie du circuit 38A.

Le chronogramme E représente les signaux de commande d'écriture W1, W2, W3 des registres 61, 62, 63 du tampon 31.

Lorsqu'un message est reçu, le circuit extracteur d'horloge 16 de la figure 1 délivre le signal d'horloge régénéré F représenté sur le chronogramme A. Dès que le dispositif de détection d'indicateur 37 délivre le signal SD indiquant la présence d'un délimiteur de début de trame, le signal de sortie CFm du circuit 38A de la figure 8 délivre une impulsion à "0" logique, qui synchronise l'horloge mot reçue Fm. Après réception des 10 premiers bits transmis après l'indicateur de début de trame, c'est-à-dire au bout d'une période mot Tm égale à 10 périodes de l'horloge F, le signal WB issu du circuit 38A de la figure 8 prend la valeur "1" logique comme représenté à l'instant t1 sur le chronogramme D. Le signal WB déclenche alors le décalage du registre 33A de la figure 10 et les signaux W1, W2, W3 représentés sur le chronogramme E apparaissent à la sortie du registre 33A. Les trois signaux W1, W2, W3 ont une fréquence égale à un tiers de la fréquence mot Fm0, le signal W1 est calé sur Fm0, W2 est en retard par rapport à W1 d'une période mot Tm et le signal W3 est en retard de deux périodes mot Tm par rapport au signal W1. Ainsi l'intervalle de temps pendant lequel les données sont accessibles dans l'un des registres 61, 62, 63 représentés à la figure 9 est égal à trois fois la période d'horloge mot Tm.

La figure 11 représente le circuit permettant de générer les signaux de commande R1 et R2 du multiplexeur 64 de la figure 9. Ce circuit fait partie également du circuit de commande 33 du dispositif tampon. Ce circuit comprend un registre décalage 33B identique au registre 33A de la figure 10. Les entrées parallèles reçoivent les mêmes valeurs de préchargement. La troisième sortie R3 est rebouclée sur l'entrée série du registre. L'entrée S1 est forcée 0 tandis que l'entrée SO reçoit un signal RB. L'entrée d'horloge du registre 33B reçoit un signal d'horloge mot locale fm. Le signal RB commande la génération des signaux d'horloge R1, R2, R3 de la même façon que le signal WB de la figure 10 commande les signaux W1, W2, W3. Le signal RB, synchrone de l'horloge mot locale fm, se déduit du signal WB synchrone de l'horloge mot reçue Fm, dans un dispositif unifieur qui permet le transfert de synchronisme et introduit un retard, de 1,5 Tm en valeur moyenne, entre l'affirmation de WB et celle de RB. Ce retard est tel que la sortie d'un registre (61, 62 ou 63) est lue nominalement au mileu de la période de 3 Tm pendant laquelle elle conserve la même information. Le signal RB revient à "0" logique lorsque, après réception d'un indicateur de fin de trame ED, le signal WB étant revenu à "0" logique et l'horloge W1-3 s'étant arrêtée dans une certaine phase, l'horloge R1-3 atteint la même phase. Le signal RB indique la présence de mots de la trame reçue à la sortie du tampon 39.

La logique d'alarme UF/OF est fondée sur une succession des coïncidences entre les phases des horloges W1-3 et R1-3. Le chronogramme F de la figure 12 représente le signal RB, et le chronogramme G représente le signal d'horloge mot locale fm. Comme précédemment les signaux R1, R2 et R3 représentés sur le chronogramme H, ont une fréquence égale à un tiers de la fréquence d'horloge mot locale fm. Le signal R1 est calé sur le signal fm, il apparaît pour la première fois lorsque RB s'affirme à l'instant T2.

Le signal R2 est en retard d'une période de l'horloge mot locale et le signal R3 est en retard de deux périodes de l'horloge mot locale par rapport au signal R1.

Nous voyons que grâce à la réalisation qui vient d'être décrite, les registres 61, 62, 63 du dispositif tampon 39 sont commandés en écriture par des signaux W1, W2, W3 qui sont synchronisés par l'horloge mot reçu Fm tandis que les mêmes registres sont lus par les signaux de commande du multiplexeur 64 qui sont dérivés du signal d'horloge mot locale fm. Ainsi, même si la phase de l'horloge locale dérive par rapport à celle de l'horloge régénérée, les mots reçus pourront tout de même être transférés vers le dispositif de décodage. Il conviendra tout de même que la trame soit assez courte et que la dérive du signal d'horloge locale soit suffisamment faible pour qu'en fin de message le déphasage entre l'horloge locale et l'horloge régénérée soit inférieur à ± 0,5 Tm. Toutefois si tel n'était pas le cas, il conviendrait alors de prévoir un dispositif tampon comprenant plus de trois registres et un multiplexeur ayant un nombre d'entrées correspondant. De même les circuits des figures 10 et 11 devraient être modifiés et utiliser des registres à décalages 33A, 33B comprenant autant d'étages que de registres dans le dispositif tampon. Les explications données précédemment dans le cas d'un tampon comprenant trois registres peuvent se généraliser aisément pour un nombre P quelconque de registres. Il est donc inutile de décrire plus en détail la façon de réaliser le cas général.

En aval du dispositif tampon 39, le transfert des données reçues peut être commandé par des signaux synchronisés exclusivement sur l'horloge locale fm. Il en est ainsi du registre d'entrée 36 du décodeur 10, de son registre de sortie 32 et de la bascule 32A, du démultiplexeur 31, du registre 35 et du détecteur d'erreur 17.

Il va de soi que le mode de réalisation décrit précédemment pourrait être adapté à un code quelconque MB/NB selon l'invention dans lequel les indicateurs sont constitués par un multiple quelconque de N bits. Cependant la description qui précède montre que la réalisation de dispositifs de codage et de décodage est simplifiée si l'on utilise des mots de donnée et des mots de code comprenant le minimum de bits. En particulier la taille des dispositifs de codage et de décodage est d'autant plus grande que les mots de données et les mots de code comprennent davantage de bits. Compte tenu des technologies actuellement disponibles, il convient de noter que le choix d'un code 8B/10B est celui qui permet le meilleur rapport performance/coût pour la mise en oeuvre de l'invention.

EP 0 269 481 B1

**Revendications**

1. Procédé de transmission de données numériques selon lequel chaque mot de donnée comprenant M bits est codé par un mot de code associé comprenant N bits, N étant supérieur à M, chaque mot de code étant destiné à être transmis en série, une succession de mots de code formant un message, ledit message étant accompagné par au moins un indicateur transmis en série, chacun desdits mots de code ayant les propriétés suivantes :

– il ne contient pas plus de quatre "1" logiques ou quatre " 0" logiques consécutifs ;
– il ne commence ni ne se termine par trois "1" logiques ou trois "0" logiques consécutifs ;
– sa "charge", c'est-à-dire la différence algébrique entre le nombre de "1" logiques et le nombre de "0" logiques qui le constituent est au plus égale a 1 en valeur absolue si N est impair ou a 2 en valeur absolue si N est pair, ledit procédé de transmission étant caractérisé en ce que tout indicateur comporte un nombre de bits égal à N ou un multiple de N et a les propriétés suivantes :
– il ne contient pas plus de quatre "1" logiques ou quatre "0" logiques consécutifs ;
– il ne commence ni ne se termine par plus de deux "1" logiques ou plus de deux "0" logiques consécutifs;
– la distance de Hamming entre un indicateur et un mot formé par toute séquence constituée par autant de bits consécutifs que l'indicateur, extraite d'un message quelconque est au moins égale à deux.

2. Procédé de transmission selon la revendication précédente caractérisé en ce que N est pair.

3. Procédé de transmission selon la revendication 2 caractérisé en ce que tout indicateur a une charge nulle, c'est-à-dire contient autant de "1" logiques que de "0" logiques.

4. Procédé de transmission selon l'une des revendications précédentes caractérisé en ce que le nombre d'indicateurs est au moins égale à deux et en ce que la distance de Hamming entre deux indicateurs quelconques est au moins égale à deux.

5. Procédé de transmission selon l'une des revendications 2 à 4 caractérisé en ce que, parmi les mots de données possibles, certains sont associés à un seul mot de code de charge nulle et les autres, appelés mots de code chargés, sont associés chacun à deux mots de code de charges opposées, non nulles et en ce que, lorsqu'un mot de donnée est associé à deux mots de code de charges opposées, un tel mot de donnée est codé par celui des deux mots de code qui a une charge opposée à la charge du précédent mot de code de charge non nulle du message.

6. Procédé de transmission selon la revendication précédente caractérisé en ce que les deux mots de code chargés associés au même mot de données sont complémentaires.

7. Procédé de transmission selon l'une des revendications précédentes caractérisé en ce que les mots de code et les indicateurs sont envoyés en série sur un canal de transmission après un codage du type NRZ.

8. Procédé de transmission selon l'une des revendications 2 à 7 caractérisé en ce que les mots de données comprennent huit bits, les mots de code dix bits et les indicateurs vingt bits.

9. Procédé de transmission selon l'une des revendications précédentes caractérisé en ce que les mots de donnée sont obtenus à partir de mots "utilisateur", directement si ces derniers sont de même longueur ou après multiplexage si les mots "utilisateur" ont une longueur multiple de la longueur des mots de donnée et en ce que, dans ce dernier cas, les mots de donnée reçus sont démultiplexés pour reconstituer lesdits mots "utilisateur".

10. Procédé de transmission selon l'une des revendicationsprécédentes caractérisé en ce que les messages sont transmis par blocs, chaque bloc comprenant un nombre déterminé de mots "utilisateur" auxquels sont ajoutés des mots de clé obtenus à partir desdits mots "utilisateur" du message par un codage du type "Reed-Solomon" et en ce que les mots "utilisateur" et les mots de clé d'un bloc reçu sont traités par un procédé de détection et/ou correcteur d'erreur du type "Reed-Solomon".

11. Dispositif d'émission pour système de transmission de données numériques comprenant un dispositif de codage (1) recevant des mots de donnée comprenant M bits en parallèle et délivrant des mots de code comprenant N bits en parallèle, N étant supérieur à M, à un dispositif de conversion parallèle-série (2), une horloge locale (13) reliée à un dispositif de commande (3,23) fournissant des signaux de commande et de synchronisation auxdits dispositifs de codage (1) et de conversion (2), de façon à émettre en série des successions d'indicateurs et de mots de code formant des messages, ledit dispositif de codage (1) comprenant des moyens (21) pour générer, en fonction de chaque mot de donnée, un mot de code ayant les propriétés suivantes :

– il ne contient pas plus de quatre "1" logiques ou quatre "0" logiques consécutifs,
– il ne commence ni ne se termine par plus de deux "1" logiques ou plus de deux "0" logiques consécutifs,
chaque mot de code ayant une charge au plus égale à 1 en valeur absolue si N est impair ou à 2 en valeur absolue si N est pair,
– ledit dispositif d'émission étant caractérisé en ce que ledit dispositif de codage comprend en outre des moyens pour générer en fonction de signaux de commande un indicateur ayant les propriétés suivantes :

22

– il ne contient pas plus de quatre "1" logiques ou quatre "0" logiques consécutifs,

– il ne commence ni ne se termine par plus de deux "1" logiques ou plus de deux "0" logiques consécutifs,

– la distance de Hamming entre un indicateur et toute séquence extraite d'un message quelconque et constituée par autant de bits consécutifs que l'indicateur est au moins égale à deux,

ledit dispositif de codage (1) pouvant délivrer soit un indicateur soit une fraction d'indicateur selon que l'indicateur comprend N bit ou un multiple de N bits.

12. Dispositif d'émission selon la revendication précédente caractérisé en ce que le dispositif de codage comprend des moyens (21) pour générer des indicateurs ayant une charge nulle.

13. Dispositif d'émission selon l'une des revendications 11 ou 12 caractérisé en ce que le dispositif de codage comprend des moyens (21) pour générer des indicateurs tels que la distance de Hamming entre deux indicateurs quelconques est au moins égale à deux.

14. Dispositif d'émission selon l'une des revendications 11 à 13 caractérisé en ce que le dispositif de codage (21) comprend des moyens pour générer, en fonction de la valeur logique d'un signal de sélection (AC), un mot de code parmi deux mots de code de charges opposées non nulles associés au même mot de donnée, ledit dispositif de codage comprenant en outre un indicateur de la charge (DC) du précédent mot de code de charge non nulle du message et un dispositif de sélection (29) délivrant ledit signal de sélection en fonction de la valeur logique dudit indicateur de charge (DC) de façon à sélectionner celui des deux mots de code qui a une charge opposée à la charge du précédent mot de code de charge non nulle du message.

15. Dispositif d'émission selon la revendication précédente caractérisé en ce que ledit indicateur de charge (DC) prend la valeur "0" logique lorsque le mot de code a une charge nulle et la valeur "1" logique dans le cas contraire, et en ce que le dispositif de sélection comprend une bascule (29B) dont l'entrée est reliée à la sortie d'une porte "OU exclusif" (29A) à deux entrées, la première entrée recevant ledit indicateur de charge, la 2ème entrée étant reliée à la sortie de ladite bascule (29B), ladite sortie fournissant ledit signal de sélection (AC).

16. Dispositif d'émission selon l'une des revendications 11 à 15 caractérisé en ce que les moyens pour générer les mots de code et les indicateurs sont constitués par une mémoire (21) recevant les mots de donnée sur M lignes d'adresse et un signal de commande d'indicateur (AFL) sur une ligne d'adresse supplémentaire, ladite mémoire (21) fournissant, en fonction de l'adresse qui lui est appliquée, des mots de N bits constituant des mots de code ou des indicateurs ou des fractions d'indicateurs.

17. Dispositif d'émission selon les revendications 15 et 16 caractérisé en ce que la mémoire (21) comporte une ligne d'adresse supplémentaire reliée à la sortie de la bascule (29B) du dispositif de sélection (29).

18. Dispositif d'émission selon l'une des revendications 11 à 17 caractérisé en ce que le dispositif de codage (1) reçoit des mots de huit bits et délivre des mots de dix bits.

19. Dispositif d'émission selon l'une des revendications 11 à 18 caractérisé en ce que l'entrée du dispositif de codage (1) est reliée à la sortie d'un multiplexeur (26, 27), ledit multiplexeur comprenant M lignes de sortie et un multiple de M lignes d'entrée.

20. Dispositif d'émission selon l'une des revendications 11 à 19 caractérisé en ce qu'il comprend un générateur de clé (15) du type "Reed-Solomon" recevant des mots "utilisateur" comportant un multiple entier de M bits et délivrant sur sa sortie des mots de clé comprenant le même nombre de bits, ladite sortie étant reliée à l'entrée dudit multiplexeur.

## Claims

1. A method for transmission of digital data in which each data word including M bits is encoded by an associated code word including N bits, N being greater than M, each code word being intended to be transmitted serially, a succession of code words forming a message, said message being accompanied by at least one indicator transmitted serially, each of said code words having the following properties :

– it contains no more than four consecutive logical ones or four consecutive logical zeroes ;

– it neither begins nor ends with three consecutive logical ones or three consecutive logical zeroes ;

– its "charge", that is the algebraic difference between the number of logical ones and the number of logical zeroes which it comprises equals no more than 1 as an absolute value if N is odd, or 2 as an absolute value if N is even, said transmission method being characterized in that each indicator includes a number of bits equal to N or a multiple of N and has the following properties :

– it contains no more than four consecutive logical ones or four consecutive logical zeroes ;

– it neither begins nor ends with more that two consecutive logical ones or two consecutive logical zeroes;

– the Hamming distance between an indicator and a word formed by any sequence constituted by as many bits as the indicator, extracted from any message, is at least equal to two.

2. A transmission method according to the preceding claim, characterized in that N is even.

EP 0 269 481 B1

3. A transmission method according to claim 2, characterized in that each indicator has a zero charge, that is it contains as many logical ones as logical zeroes.

4. A transmission method according to one of the preceding claims, characterized in that the number of indicators is at least equal to two and in that the Hamming distance between any two indicators is at least equal to two.

5. A transmission method according to one of claims 2 to 4, characterized in that, among the possible data words, certain ones are associated with a single code word having a zero charge, and the others, called charged code words, are each associated with two code words having opposite, non-zero charges and in that, when a data word is associated with two code words of opposite charges, one such data word is encoded by the one of the two code words that has a charge opposite the charge of the preceding code word having a non-zero charge in the message.

6. A transmission method according to the preceding claim, characterized in that the two charged code words associated with the same data word are complementary.

7. A transmission method according to one of the preceding claims, characterized in that the code words and the indicators are sent serially over a transmission channel after an encoding of the NRZ type.

8. A transmission method according to one of claims 2 to 7, characterized in that the data words include eight bits, the code words ten bits and the indicators twenty bits.

9. A transmission method according to one of the preceding claims, characterized in that the data words are obtained from "user" words, directly if these "user" words are of the same length or following multiplexing if the "user" words have a length that is a multiple of the length of the data words, and in that, in the latter case, the data words received are demultiplexed so as to reconstitute the "user" words.

10. A transmission method according to one of the preceding claims, characterized in that the messages are transmitted in frames, each frame including a predetermined number of "user" words to which are added key words obtained from said "user" words of the message by encoding of the "Reed-Solomon" type and in that the "user" words and the key words of a frame that has been received are processed by an error detection and/or correction method of the "Reed-Solomon" type.

11. Transmission apparatus for a digital data transmission system including an encoding device (1) receiving data words including M bits in parallel and delivering code words including N bits in parallel, N being greater than M, to a parallel/serial conversion device (2), a local clock (13) connected to a control device (3, 23) supplying control and synchronization signals to said encoding (1) and conversion (2) devices, such as to transmit in series successions of indicators and code words forming messages, said encoding device (1) including means (21) for generating, as a function of each data word, a code word having the following properties :
- it contains no more than four consecutive logical ones or four consecutive logical zeroes ;
- it neither begins nor ends with more than two consecutive logical ones or two consecutive logical zeroes, each code word having a charge at most equal to 1 as an absolute value if N is odd, or 2 as an absolute value if N is even,
- said transmission apparatus being characterized in that said encoding device further includes means for generating, as a function of control signals, an indicator having the following properties :
- it contains no more than four consecutive logical ones or four consecutive logical zeroes,
- it neither begins nor ends with more than two consecutive logical ones or more than two consecutive logical zeroes,
- the Hamming distance between an indicator and any sequence extracted from any message and comprising as many consecutive bits as the indicator is at least equal to two, said encoding device (1) being capable of delivering either an indicator or a fraction of an indicator depending on whether the indicator includes N bits or a multiple of N bits.

12. Transmission apparatus according to the preceding claim, characterized in that the encoding device includes means (21) for generating indicators having a zero charge.

13. Transmission apparatus according to one of claims 11 or 12, characterized in that the encoding device includes means (21) for generating indicators such that the Hamming distance between any two indicators is at least equal to two.

14. Transmission apparatus according to one of claims 11 to 13, characterized in that the encoding device (1) includes means for generating, as a function of the logical value of a selection signal (AC), one code word from among two code words having opposite non-zero charges associated with the same data word, said encoding device further including a charge indicator (DC) of the preceding non-zero charge code word of the message and a selection device (29) delivering said selection signal as a function of the logical value of said charge indicator (DC), such as to select the one of the two code words that has a charge opposite the charge of the preceding non-zero charge code word of the message.

15. Transmission apparatus according to the preceding claim, characterized in that said charge indicator

24

(DC) assumes the value of logical zero when'the code word has a zero charge and the value of logical one in the contrary case, and in that the selection device includes a toggle (29B), the input of which is connected to the output of an "exclusive OR" gate (29A) having two inputs, the first input receiving said charge indicator, the second input being connected to the output of said toggle (29B), said output delivering said selection signal (AC).

16. Transmission apparatus according to one of claims 11 to 15, characterized in that the means for generating the code words and the indicators comprise a memory (21) receiving the data words on M address lines and an indicator control signal (AFL) on an additional address line, said memory (21) supplying as a function of the address applied to it, words of N bits comprising code words or indicators or fractions of indicators.

17. Transmission apparatus according to claims 15 and 16, characterized in that the memory (21) includes an additional address line connected to the output of the toggle (29B) of the selection device (29).

18. Transmission apparatus according to one of claims 11 to 17, characterized in that the encoding device (1) receives words of eight bits and delivers words of ten bits.

19. Transmission apparatus according to one of claims 11 to 18, characterized in that the input of the encoding device (1) is connected to the output of a multiplexer (26, 27), said multiplexer including M output lines and a multiple of M input lines.

20. Transmission apparatus according to one of claims 11 to 19, characterized in that it includes a key generator (15) of the "Reed-Solomon" type receiving "user" words including an integral multiple of M bits and delivering at its output key words including the same number of bits, said output being connected to the input of said multiplexer.

## Ansprüche

1. Verfahren zur Übertragung digitaler Daten, in dem jedes Datenwort M Bits enthält und durch ein zugeordnetes Kodewort mit N Bits, mit N größer als M, kodiert ist, wobei jedes Kodewort dazu vorgesehen ist, seriell übertragen zu werden, wobei eine Folge von Kodewörtern eine Nachricht bildet, wobei die Nachricht von wenigstens einem seriell übertragenen Zeiger begleitet wird und wobei jedes der Kodewörter die folgenden Eigenschaften besitzt :

– es enthält nicht mehr als vier aufeinanderfolgende logische "1" oder vier aufeinanderfolgende logische "0" ;

– weder beginnt noch endet es mit drei aufeinanderfolgenden logischen "1" oder drei aufeinanderfolgenden logischen "0" ;

– seine "Ladung", d.h. die algebraische Differenz zwischen der Anzahl der es bildenden logischen "1" und der Anzahl der es bildenden logischen "0" ist betragsmäßig höchstens 1, falls N ungeradzahlig ist, oder betragsmäßig höchstens gleich 2, falls N geradzahlig ist, wobei das Übertragungsverfahren dadurch gekennzeichnet ist, daß jeder Zeiger eine Anzahl von Bits, die gleich N oder einem Vielfachen von N ist, enthält und die folgenden Eigenschaften besitzt :

– er enthält nicht mehr als vier aufeinanderfolgende logische "1" oder vier aufeinanderfolgende logische "0" ;

– weder beginnt noch endet er mit mehr als zwei aufeinanderfolgenden logischen "1" oder mehr als zwei aufeinanderfolgenden logischen "0" ;

– der Hammingabstand zwischen einem Zeiger und einem Wort, das durch jede Folge, die von ebensovielen aufeinanderfolgenden Bits wie der Zeiger aufgebaut und aus irgendeiner Nachricht entnommen wird, gebildet wird, wenigstens gleich Zwei ist.

2. Übertragungsverfahren gemäß dem vorangehenden Anspruch, dadurch gekennzeichnet, daß N geradzahlig ist.

3. Übertragungsverfahren gemäß Anspruch 2, dadurch gekennzeichnet, daß jeder Zeiger eine Ladung Null besitzt, d.h. ebensoviele logische "1" wie logische "0" enthält.

4. Übertragungsverfahren gemäß einem der vorangehenden Ansprüche, dadurch gekennzeichnet, daß die Anzahl der Zeiger wenigstens gleich Zwei ist, und daß der Hammingabstand zwischen irgendwelchen zwei Zeigern wenigstens gleich Zwei ist.

5. Übertragungsverfahren gemäß einem der Ansprüche 2 bis 4, dadurch gekennzeichnet, daß unter den möglichen Datenwörtern gewisse Wörter einem einzigen Kodewort mit der Ladung Null zugeordnet sind und die anderen, welche Wörter mit Kodeladung genannt werden, jeweils zwei Kodewörtern mit von Null verschiedenen, entgegengesetzten Ladungen zugeordnet sind, und daß dann, wenn ein Datenwort zwei Kodewörtern mit entgegengesetzten Ladungen zugeordnet ist, ein solches Datenwort durch dasjenige der zwei Kodewörter kodiert wird, das eine Ladung besitzt, die der Ladung des vorhergehenden Kodeworts mit von Null verschiedener Ladung der Nachricht entgegengesetzt ist.

6. Übertragungsverfahren gemäß dem vorangehenden Anspruch, dadurch gekennzeichnet, daß die zwei geladenen Kodewörter, die demselben Datenwort zugeordnet sind, komplementär sind.

7. Übertragungsverfahren gemäß einem der vorangehenden Ansprüche, dadurch gekennzeichnet, daß die Kodewörter und die Zeiger nach einer Kodierung vom NRZ-Typ seriell über einen Übertragungskanal geschickt werden.

8. Übertragungsverfahren gemäß einem der Ansprüche 2 bis 7, dadurch gekennzeichnet, daß die Datenwörter 8 Bits, die Kodewörter 10 Bits und die Zeiger 20 Bits umfassen.

9. Übertragungsverfahren gemäß einem der vorangehenden Ansprüche, dadurch gekennzeichnet, daß die Datenwörter aus den "Benutzer"-Wörtern direkt erhalten werden, falls diese letzteren die gleiche Länge besitzen, oder nach einer Multiplex-Verarbeitung erhalten werden, falls die "Benutzer"- Wörter eine Länge besitzen, die ein Vielfaches der Länge der Datenwörter beträgt, und daß im letzteren Fall die empfangenen Datenwörter einer Demultiplex-Verarbeitung unterzogen werden, um die "Benutzer"-Wörter wiederherzustellen.

10. Übertragungsverfahren gemäß einem der vorangehenden Ansprüche, dadurch gekennzeichnet, daß die Nachrichten in Blökken übertragen werden, wobei jeder Block eine bestimmte Anzahl von "Benutzer"-Wörtern umfaßt, denen Schlüsselwörter zugefügt werden, die aus den "Benutzer"-Wörtern der Nachricht durch eine Kodierung vom "Reed-Solomon"-Typ erhalten werden, und daß die "Benutzer"-Wörter und die Schlüsselwörter eines empfangenen Blocks mit einem Fehlerermittlungs- und/oder Fehlerkorrekturverfahren vom "Reed-Solomon"-Typ bearbeitet werden.

11. Sendevorrichtung für Übertragungssystem von digitalen Daten, mit einer Kodierungsvorrichtung (1), die Datenwörter mit M Bits parallel empfängt und Kodewörter mit N Bits, mit N größer als M, an eine Parallel/Seriell-Wandlervorrichtung parallel ausgibt, einem lokalen Taktgeber (13), der mit einer Steuervorrichtung (3, 23) verbunden ist, die an die Kodierungsvorrichtung (1) und die Wandlervorrichtung (2) Steuer- und Synchronisationssignale liefert, derart, daß die Nachrichten bildenden Abfolgen von Zeigern und Kodewörtern seriell ausgesandt werden, wobei die Kodierungsvorrichtung (1) Mittel (21) umfaßt, um in Abhängigkeit eines jeden Datenwortes ein Kodewort zu erzeugen, das die folgenden Eigenschaften besitzt :
   – es enthält nicht mehr als vier aufeinanderfolgende logische "1" oder vier aufeinanderfolgende logische "0",
   – weder beginnt noch endet es mit mehr als zwei aufeinanderfolgenden logischen "1" oder mehr als zwei aufeinanderfolgenden logischen "0", wobei jedes Kodewort eine Ladung besitzt, die betragsmäßig höchstens gleich 1 ist, falls N ungeradzahlig ist, oder betragsmäßig höchstens gleich 2 ist, falls N geradzahlig ist,
   – wobei die Sendevorrichtung dadurch gekennzeichnet ist, daß die Kodierungsvorrichtung außerdem Mittel zum Erzeugen eines Zeigers in Abhängigkeit von den Steuersignalen umfaßt, wobei der Zeiger die folgenden Eigenschaften besitzt :
   – er enthält nicht mehr als vier aufeinanderfolgende logische "1" oder vier aufeinanderfolgende logische "0",
   – weder beginnt noch endet er mit mehr als zwei aufeinanderfolgenden logischen "1" oder mehr als zwei logischen "0",
   – der Hammingabstand zwischen einem Zeiger und jeder aus irgendeiner Nachricht entnommenen Folge, die durch ebensoviele aufeinanderfolgende Bits wie der Zeiger aufgebaut wird, ist wenigstens gleich zwei,
   – wobei die Kodierungsvorrichtung (1) entweder einen Zeiger oder einen Teilzeiger ausgeben kann, je nachdem, ob der Zeiger N Bits oder ein Vielfaches von N Bits umfaßt.

12. Sendevorrichtung gemäß dem vorangehenden Anspruch, dadurch gekennzeichnet, daß die Kodierungsvorrichtung Mittel (21) zum Erzeugen der Zeiger mit einer Null-Ladung umfaßt.

13. Sendevorrichtung gemäß einem der Ansprüche 11 oder 12, dadurch gekennzeichnet, daß die Kodierungsvorrichtung Mittel (21) zum Erzeugen von Zeigern umfaßt, derart, daß der Hammingabstand zwischen irgendwelchen zwei Zeigern wenigstens gleich zwei ist.

14. Sendevorrichtung gemäß einem der Ansprüche 11 bis 13, dadurch gekennzeichnet, daß die Kodierungsvorrichtung (21) Mittel umfaßt, die in Abhängigkeit vom logischen Wert eines Auswahlsignals (AC) aus zwei Kodewörtern, die demselben Datenwort zugeordnet sind und von Null verschiedene, entgegengesetzte Ladungen besitzen, ein Kodewort erzeugen, wobei die Kodierungsvorrichtung außerdem einen Ladungsanzeiger (DC) des vorhergehenden, von Null verschiedenen Kodeworts der Nachricht und eine Auswahlvorrichtung (29), die das Auswahlsignal in Abhängigkeit vom logischen Wert des Ladungsanzeigers (DC) ausgibt, umfaßt, derart, daß dasjenige der zwei Kodewörter gewählt wird, das eine zur Ladung des vorhergehenden, von Null verschiedenen Ladungskodewortes der Nachricht entgegengesetzte Ladung besitzt.

15. Sendevorrichtung gemäß dem vorangehenden Anspruch, dadurch gekennzeichnet, daß der Ladungsanzeiger (DC) den logischen Wert "0" annimmt, wenn das Kodewort eine Null-Ladung besitzt, während er im entgegengesetzten Fall den logischen Wert "1" annimmt, und daß die Auswahlvorrichtung eine Kippschaltung (29 B) umfaßt, deren Eingang mit dem Ausgang eines "Exklusiv-ODER"-Gatters (29A) mit zwei Eingängen verbunden ist, wobei der erste Eingang den Ladungszeiger empfängt, wobei der zweite Eingang mit dem Ausgang der Kippschaltung (29B) verbunden ist und wobei der Ausgang das Auswahlsignal (AC) liefert.

16. Sendevorrichtung gemäß einem der Ansprüche 11 bis 15, dadurch gekennzeichnet, daß die Mittel zum Erzeugen der Kodewörter und der Zeiger von einem Speicher (21) gebildet werden, die über M Adreßleitungen die Datenwörter und über eine zusätzliche Adreßleitung ein Steuersignal des Zeigers (AFL) empfangen, wobei der Speicher (21) in Abhängigkeit von der in ihn eingegebenen Adresse Wörter von N Bits liefert, die Kodewörter oder Zeiger oder Teilzeiger bilden.

17. Sendevorrichtung gemäß den Ansprüchen 15 und 16, dadurch gekennzeichnet, daß der Speicher (21) eine zusätzliche Adreßleitung enthält, die mit dem Ausgang der Kippschaltung (29B) der Auswahlvorrichtung (29) verbunden ist.

18. Sendevorrichtung gemäß einem der Ansprüche 11 bis 17, dadurch gekennzeichnet, daß die Kodierungsvorrichtung (1) Wörter von 8 Bits empfängt und Wörter von 10 Bits ausgibt.

19. Sendevorrichtung gemäß einem der Ansprüche 11 bis 18, dadurch gekennzeichnet, daß der Eingang der Kodierungsvorrichtung (1) mit dem Ausgang eines Multiplexers (26, 27) verbunden ist, wobei der Mulitplexer M Ausgangsleitungen und ein Vielfaches von M Eingangsleitungen umfaßt.

20. Sendevorrichtung gemäß einem der Ansprüche 11 bis 19, dadurch gekennzeichnet, daß er einen Schlüsselgenerator (15) vom "Reed-Solomon"-Typ umfaßt, der "Benutzer"-Wörter empfängt, die ein ganzzahliges Vielfaches von M Bits enthalten und der an seinen Ausgang Schlüsselwörter ausgibt, die die gleiche Anzahl von Bits enthalten, wobei der Ausgang mit dem Eingang des Multiplexers verbunden ist.

FIG. 1

FIG. 2

FIG. 3

| ADRESSE | | SORTIE MEMOIRE | |
|---|---|---|---|
| MOTS DE DONNEE | AC | MOTS DE CODE | DC |
| M0 | 0 | TZ0 | 0 |
| M1 | 0 | TZ1 | 0 |
| M2 | 0 | TZ2 | 0 |
| ⋮ | ⋮ | ⋮ | ⋮ |
| ⋮ | ⋮ | ⋮ | ⋮ |
| M151 | 0 | TZ151 | 0 |
| M152 | 0 | TP0 | 1 |
| M153 | 0 | TP1 | 1 |
| ⋮ | ⋮ | ⋮ | ⋮ |
| ⋮ | ⋮ | ⋮ | ⋮ |
| M255 | 0 | TP103 | 1 |
| M0 | 1 | TZ0 | 0 |
| M1 | 1 | TZ1 | 0 |
| M2 | 1 | TZ2 | 0 |
| ⋮ | ⋮ | ⋮ | ⋮ |
| ⋮ | ⋮ | ⋮ | ⋮ |
| M151 | 1 | TZ151 | 0 |
| M152 | 1 | TM0 | 1 |
| M153 | 1 | TM1 | 1 |
| ⋮ | ⋮ | ⋮ | ⋮ |
| ⋮ | ⋮ | ⋮ | ⋮ |
| M 255 | 1 | TM103 | 1 |

FIG. 4A

FIG. 4B

EP 0 269 481 B1

| ADRESSE | SORTIE MEMOIRE | |
|---|---|---|
| MOTS DE CODE OU ERREURS | MOTS DE DONNEE | E |
| C0 | D0 | 0 |
| C1 | D1 | 0 |
| C2 | D2 | 0 |
| — — | — — | — — |
| × | — | 1 |
| — | — | |
| C1023 | D1023 | 1023 |

## FIG. 5A

## FIG. 5B

FIG. 6

33

FIG. 7

FIG. 8

FIG 9

FIG. 10

FIG. 11

FIG. 12